(19) Europäisches Patentamt
European Patent Office
Office européen des brevets

(11) **EP 4 752 578 A1**

(12) **EUROPEAN PATENT APPLICATION**
published in accordance with Art. 153(4) EPC

(43) Date of publication:
03.06.2026 Bulletin 2026/23

(21) Application number: 25739174.8

(22) Date of filing: 10.01.2025

(51) International Patent Classification (IPC):
*G01R 31/392* *(2019.01)*    *G01R 31/396* *(2019.01)*
*G01R 31/382* *(2019.01)*

(52) Cooperative Patent Classification (CPC):
G01R 31/396; G01R 31/3646; G01R 31/367;
G01R 31/382; G01R 31/3835; G01R 31/392;
H01M 10/425; H01M 10/441; H01M 10/48;
H01M 10/482; H01M 2010/4271; H01M 2220/20;
Y02E 60/10

(86) International application number:
PCT/KR2025/000681

(87) International publication number:
WO 2025/151009 (17.07.2025 Gazette 2025/29)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 12.01.2024 KR 20240005634
12.01.2024 KR 20240005640
12.01.2024 KR 20240005647
12.01.2024 KR 20240005648
12.01.2024 KR 20240005656
12.01.2024 KR 20240005657

(71) Applicant: **LG Energy Solution, Ltd.**
**Seoul 07335 (KR)**

(72) Inventors:
• **KIM, Ji-Yeon**
**Daejeon 34122 (KR)**
• **KIM, Young-Deok**
**Daejeon 34122 (KR)**
• **PARK, Jun-Cheol**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY MANAGING APPARATUS AND METHOD THEREOF**

(57)    A battery management apparatus according to the present disclosure includes a profile obtaining unit configured to obtain a first profile for each of a plurality of batteries included in a battery pack; and a diagnosing unit configured to calculate a target value for each of the plurality of batteries based on a first target point or a target ratio for each of the plurality of first profiles, generate a distribution profile representing a corresponding relationship between the calculated plurality of target values and the number of each of the plurality of target values, determine whether the distribution profile satisfies a predetermined condition, and diagnose a state of the battery pack based on the determination result.

FIG. 1

BATTERY MANAGEMENT APPARATUS ~100

PROFILE OBTAINING UNIT ~110

DIAGNOSING UNIT ~120

STORAGE UNIT ~130

## Description

TECHNICAL FIELD

The present disclosure relates to a battery management apparatus and method, and more particularly, to a battery management apparatus and method capable of diagnosing a state of a battery pack.

This application is based on and claims priority from Korean Patent Application Nos. 10-2024-0005648, 10-2024-0005656, 10-2024-0005647, 10-2024-0005634, 10-2024-0005640 and 10-2024-0005657, filed on January 12, 2024, with the Korean Intellectual Property Office, the disclosure of which is incorporated herein in its entirety by reference.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Batteries are used in various fields, and in fields where batteries are being widely used recently, such as electric vehicles or smart grid systems, batteries with large capacities are often required. In order to increase the capacity of a battery pack, there may be a method of increasing the capacity of the secondary battery, that is, the battery cell itself. However, in this case, while the effect of increasing the capacity is not great, there is a physical limitation on the expansion of the size of the secondary battery, and management is inconvenient. Therefore, battery packs in which a number of battery cells are connected in series and parallel are usually widely used.

DISCLOSURE

Technical Problem

The present disclosure is designed to solve the problems of the related art, and therefore the present disclosure is directed to providing a battery management apparatus and method capable of diagnosing a degradation imbalance state among a plurality of batteries included in a battery pack.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

A battery management apparatus according to one aspect of the present disclosure comprises: a profile obtaining unit configured to obtain a first profile for each of a plurality of batteries included in a battery pack; and a diagnosing unit configured to calculate a target value for each of the plurality of batteries based on a first target point or a target ratio for each of the plurality of first profiles, generate a distribution profile representing a corresponding relationship between the calculated plurality of target values and the number of each of the plurality of target values, determine whether the distribution profile satisfies a predetermined condition, and diagnose a state of the battery pack based on the determination result.

The first profile may be a positive electrode profile or a negative electrode profile.

The first target point may be a participation start point indicating a point where a charging reaction starts or a discharging reaction ends in the first profile, or a participation end point indicating a point where the charging reaction ends or the discharging reaction starts in the first profile.

The target ratio may be a change ratio of the first profile to a preset reference profile.

The diagnosing unit may be configured to diagnose the state of the battery pack as a degradation imbalance state when the distribution profile does not satisfy the predetermined condition.

The diagnosing unit may be configured to compare a feature value of the distribution profile with a preset threshold value when the distribution profile satisfies the predetermined condition.

The diagnosing unit may be configured to diagnose the state of the battery pack based on the comparison result.

The diagnosing unit may be configured to diagnose the state of the battery pack as a degradation imbalance state when the feature value exceeds the threshold value.

The diagnosing unit may be configured to diagnose the state of the battery pack as a degradation balance state when the feature value is less than or equal to the threshold value.

The diagnosing unit may be configured to set the threshold value based on a degradation level of the battery pack and a preset reference feature value.

The diagnosing unit may be configured to calculate a first value and a second value based on the plurality of target values.

The diagnosing unit may be configured to determine whether the distribution profile satisfies the predetermined condition based on a ratio between the first value and the second value.

The diagnosing unit may be configured to determine a minimum value, a maximum value and a reference value from the plurality of target values.

The diagnosing unit may be configured to calculate a difference between the minimum value and the reference value as the first value.

The diagnosing unit may be configured to calculate a difference between the reference value and the maximum value as the second value.

The diagnosing unit may be configured to determine a target value with the largest corresponding number among the plurality of target values as the reference value.

The diagnosing unit may be configured to determine the distribution profile as satisfying the predetermined condition when the ratio belongs to a preset threshold ratio section.

The diagnosing unit may be configured to determine the distribution profile as not satisfying the predetermined condition when the ratio does not belong to the threshold ratio section.

The diagnosing unit may be configured to calculate a SOC of the first target point based on a ratio of a capacity value of the first target point to a reference capacity set for each of the plurality of batteries.

The diagnosing unit may be configured to determine the calculated SOC as the target value.

The diagnosing unit may be configured to determine the target ratio as the target value.

The diagnosing unit may be configured to determine the target value based on a ratio between a reference ratio preset for each of the plurality of batteries and the target ratio.

The diagnosing unit may be configured to operate a function to resolve degradation imbalance or output an alarm when the state of the battery pack is diagnosed as a degradation imbalance state.

The function to resolve degradation imbalance may be a pack balancing function.

A battery pack according to another aspect of the present disclosure comprises the battery management apparatus according to one aspect of the present disclosure.

A vehicle according to still another aspect of the present disclosure comprises the battery management apparatus according to one aspect of the present disclosure.

A battery management method according to still another aspect of the present disclosure may comprise: a profile obtaining step of obtaining a first profile for each of a plurality of batteries included in a battery pack; a target value calculating step of calculating a target value for each of the plurality of batteries based on a first target point or a target ratio for each of the plurality of first profiles; a profile generating step of generating a distribution profile representing a corresponding relationship between the calculated plurality of target values and the number of each of the plurality of target values; a condition determining step of determining whether the distribution profile satisfies a predetermined condition; and a state diagnosing step of diagnosing a state of the battery pack based on the determination result.

A recording medium according to still another aspect of the present disclosure is a non-transitory readable recording medium on which a program is stored to execute a battery management method, which includes a profile obtaining step of obtaining a first profile for each of a plurality of batteries included in a battery pack; a target value calculating step of calculating a target value for each of the plurality of batteries based on a first target point or a target ratio for each of the plurality of first profiles; a profile generating step of generating a distribution profile representing a corresponding relationship between the calculated plurality of target values and the number of each of the plurality of target values; a condition determining step of determining whether the distribution profile satisfies a predetermined condition; and a state diagnosing step of diagnosing a state of the battery pack based on the determination result.

Advantageous Effects

According to one aspect of the present disclosure, a battery management apparatus according to the present disclosure may diagnose a degradation imbalance state among a plurality of batteries included in a battery pack.

The effects of the present disclosure are not limited to the effects mentioned above, and other effects not mentioned will be clearly understood by those skilled in the art from the description of the claims.

DESCRIPTION OF DRAWINGS

The accompanying drawings serve to provide further understanding of the technical features of the present disclosure together with the foregoing disclosure, and thus, the present disclosure is not construed as being limited to the drawing.

FIG. 1 is a diagram schematically illustrating a battery management apparatus according to an embodiment of the present disclosure.
FIG. 2 is a drawing schematically illustrating a positive electrode profile, a negative electrode profile, and a battery profile according to an embodiment of the present disclosure.
FIG. 3 is a drawing schematically illustrating a first distribution profile according to an embodiment of the present disclosure.
FIG. 4 is a drawing schematically illustrating a second distribution profile according to an embodiment of the present disclosure.

FIG. 5 is a drawing schematically illustrating a reference positive electrode profile, a reference negative electrode profile, and a reference profile according to an embodiment of the present disclosure.

FIG. 6 to FIG. 8 are drawings for reference in explaining an example of a procedure for generating a comparative profile used for comparison with a battery profile according to an embodiment of the present disclosure.

FIG. 9 to FIG. 11 are drawings for reference in explaining another example of a procedure for generating a comparative profile used for comparison with a battery profile according to an embodiment of the present disclosure.

FIG. 12 is a drawing illustrating an exemplary configuration of a battery pack according to another embodiment of the present disclosure.

FIG. 13 is a drawing schematically illustrating a vehicle according to another embodiment of the present disclosure.

FIG. 14 is a drawing schematically illustrating a battery management method according to another embodiment of the present disclosure.

FIG. 15 is a drawing schematically illustrating a condition determining step and a state diagnosing step of a battery management method according to another embodiment of the present disclosure.

BEST MODE

Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just an example for the purpose of illustrations only, not intended to limit the scope of the disclosure, so it should be understood that other equivalents and modifications could be made thereto without departing from the scope of the disclosure.

In addition, when explaining the present disclosure, if it is judged that the description of the related known structure or function may obscure the main point of the present disclosure, the detailed description will be omitted.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Meanwhile, the battery degrades as it is used, and the degradation states of a plurality of batteries included in a battery pack may be different from each other because charging and discharging of the battery pack are repeated or the battery pack is left unattended for a long period of time. In other words, the degradation states of the plurality of batteries included in the battery pack may not be uniform.

For example, as a battery degrades, its available capacity decreases. If the degradation states of a plurality of batteries in a battery pack are not uniform, the available capacity of each battery may be different. In this case, the available capacity of the battery pack may be determined based on the smallest available capacity among the available capacities of the plurality of batteries.

Assume that a battery pack includes 5 batteries connected in series, and that the available capacity of 4 batteries is 100 [Ah] and the available capacity of 1 battery is 90 [Ah]. In this case, the available capacity of the battery pack is 450 [Ah], not 490 [Ah]. That is, since the degradation of the plurality of batteries is uneven, there is a problem that the capacity for 40 [Ah] is not utilized.

The present disclosure provides a technology capable of diagnosing a degradation imbalance state among a plurality of batteries included in a battery pack.

Hereinafter, an embodiment of the present disclosure will be described in detail with reference to the attached drawings.

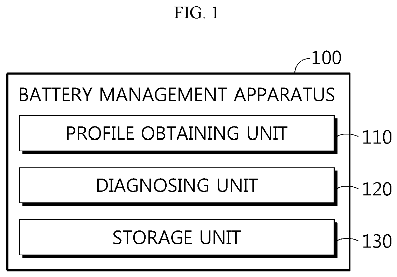

FIG. 1 is a diagram schematically illustrating a battery management apparatus 100 according to an embodiment of the present disclosure.

Referring to FIG. 1, the battery management apparatus 100 may include a profile obtaining unit 110 and a diagnosing unit 120.

The profile obtaining unit 110 may be configured to obtain a first profile for each of a plurality of batteries included in a battery pack.

Here, the battery refers to an independent cell that has a negative electrode terminal and a positive electrode terminal and is physically separable. As an example, a lithium-ion cell or a lithium polymer cell may be considered a battery. Additionally, the type of battery may be cylindrical type, prismatic type, or pouch type. In addition, the battery may mean a battery bank or a battery module in which a plurality of cells are connected in series and/or parallel. Hereinafter, for convenience of explanation, the battery is explained as meaning one independent cell.

Here, the first profile is a positive electrode profile or a negative electrode profile. And, the reference profile is a profile preset to be a reference for the first profile. For example, if the first profile is a positive electrode profile, the reference profile is a reference positive electrode profile. In another example, if the first profile is a negative electrode profile, the reference profile is a reference negative electrode profile. A specific description of the reference profile will be given later.

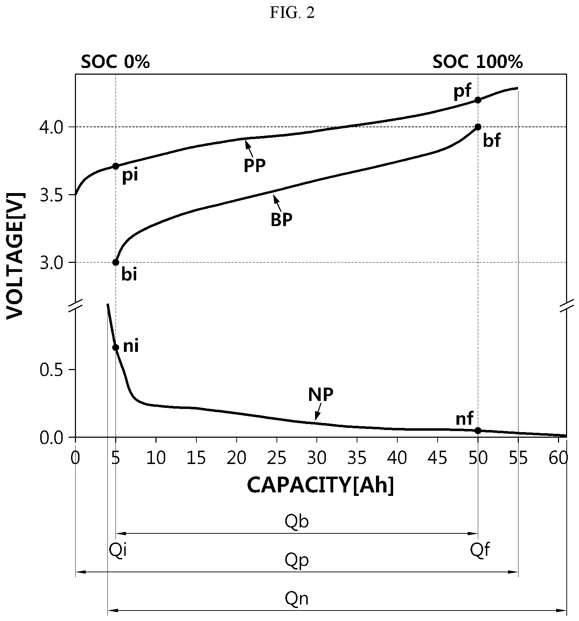

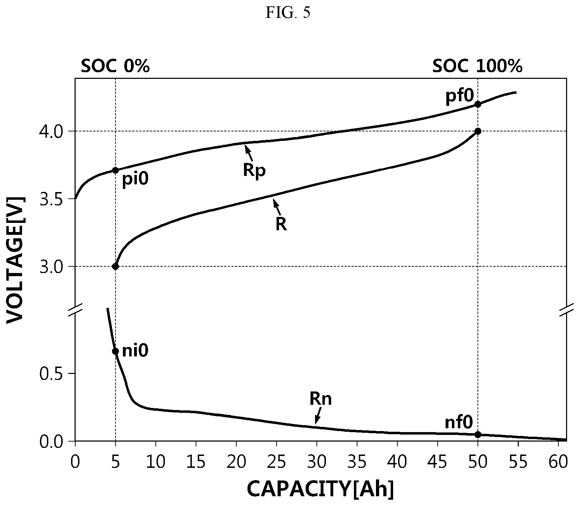

FIG. 2 is a drawing schematically illustrating a positive electrode profile PP, a negative electrode profile NP, and a battery profile BP according to an embodiment of the present disclosure, and FIG. 5 is a drawing schematically illustrating a reference positive electrode profile Rp, a reference negative electrode profile Rn, and a reference profile R according to an embodiment of the present disclosure.

In the embodiments of FIGS. 2 and 5, the horizontal axis (X-axis) represents capacity (Ah), and the vertical axis (Y-axis) represents voltage (V).

For example, the profile obtaining unit 110 may obtain a battery profile BP representing a corresponding relationship between the voltage and capacity of the battery, and adjust a preset reference positive electrode profile Rp and a reference negative electrode profile Rn to correspond to the battery profile BP to obtain a positive electrode profile PP and a negative electrode profile NP.

Here, the battery profile BP may be a profile representing the corresponding relationship between the voltage (V) and the capacity (Q) when the battery is charged. Alternatively, the battery profile BP may be a profile representing the corresponding relationship between the voltage (V) and the capacity (Q) when the battery is discharged.

The reference positive electrode profile Rp may be a profile representing a corresponding relationship between the capacity and voltage of a preset reference positive electrode cell corresponding to the positive electrode of the battery. For example, the reference positive electrode cell may be a positive electrode of a positive electrode coin half cell or a positive electrode of a 3-electrode cell. And, the reference negative electrode profile Rn may be a profile representing a corresponding relationship between the capacity and voltage of a preset reference negative electrode cell corresponding to the negative electrode of the battery. For example, the reference negative electrode cell may be a negative electrode coin half cell or a negative electrode of a 3-electrode cell.

Specifically, the profile obtaining unit 110 may obtain an adjusted positive electrode profile and an adjusted negative electrode profile by adjusting (shifting the profile) or capacity-scaling the reference positive electrode profile Rp and the reference negative electrode profile Rn, respectively. Then, the profile obtaining unit 110 may generate a comparative profile by synthesizing (summing up capacity values for the same voltage value or summing up voltage values for the same capacity value) the adjusted positive electrode profile and the adjusted negative electrode profile. The profile obtaining unit 110 may generate a plurality of comparative profiles by repeating the adjusting procedure and the synthesizing procedure for the reference positive electrode profile Rp and the reference negative electrode profile Rn. Then, the profile obtaining unit 110 may specify a comparative profile having a minimum error with respect to the battery profile BP among the plurality of comparative profiles. The profile obtaining unit 110 may determine the adjusted positive electrode profile and the adjusted negative electrode profile used to generate the specified comparative profile as the positive electrode profile PP and the negative electrode profile NP of the battery.

In relation to this, more specific embodiments in which the profile obtaining unit 110 determines the positive electrode profile PP and the negative electrode profile NP are described below with reference to FIGS. 5 to 11.

As another example, the profile obtaining unit 110 may directly receive the first profile from an external source instead of generating the first profile by itself. For example, the profile obtaining unit 110 may be connected to the external source via a wire and/or wireless connection to receive the first profile.

The diagnosing unit 120 may be configured to calculate a target value for each of the plurality of batteries based on a first target point or a target ratio for each of the plurality of first profiles.

Here, the first target point is a participation start point or participation end point included in the first profile. Specifically, if the first profile is a positive electrode profile, the first target point is a positive electrode participation start point or a positive electrode participation end point. If the first profile is a negative electrode profile, the first target point is a negative electrode participation start point or a negative electrode participation end point.

The target ratio is the change ratio of the first profile to the reference profile.

For example, if the first profile is a positive electrode profile, the target ratio is a positive electrode change ratio. The positive electrode change ratio means a change ratio [%] of the first profile with respect to the reference positive electrode profile Rp. Specifically, the positive electrode change ratio may be a shrinkage ratio or expansion ratio of the first profile with respect to the reference positive electrode profile Rp. For example, if the first profile is shrunken by 10% from the reference positive electrode profile Rp, the positive electrode change ratio is 90%. Conversely, if the first profile is expanded by 10% from the reference positive electrode profile Rp, the positive electrode change ratio is 110%.

As another example, if the first profile is a negative electrode profile, the target ratio is a negative electrode change ratio. The negative electrode change ratio means the change ratio [%] of the first profile with respect to the reference negative electrode profile Rn. Specifically, the negative electrode change ratio may be a shrinkage ratio or expansion ratio of the first profile with respect to the reference negative electrode profile Rn. For example, if the first profile is shrunken by 10% from the reference negative electrode profile Rn, the negative electrode change ratio is 90%. Conversely, if the first profile is expanded by 10% from the reference negative electrode profile Rn, the negative electrode change ratio is 110%.

The diagnosing unit 120 may be configured to generate a distribution profile representing a corresponding relationship between the generated plurality of target values and the number of each of the plurality of target values.

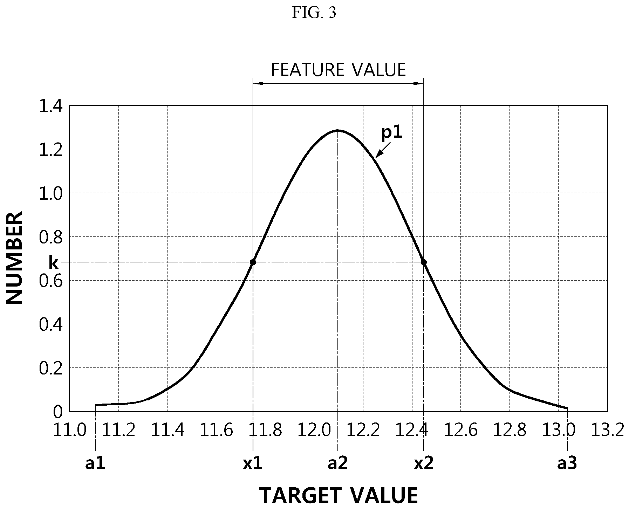

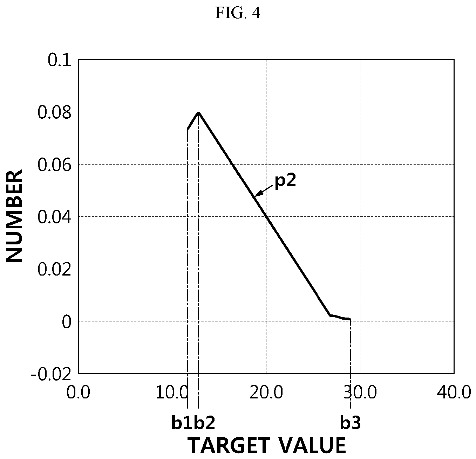

FIG. 3 is a drawing schematically illustrating a first distribution profile p1 according to an embodiment of the present disclosure, and FIG. 4 is a drawing schematically illustrating a second distribution profile p2 according to an embodiment of the present disclosure.

In the embodiments of FIGS. 3 and 4, the horizontal axis (X-axis) represents a target value, and the vertical axis (Y-axis) represents the number of each of the plurality of target values.

As explained above, the target value may be used as an indicator representing the degradation level of the battery, and the distribution profile representing the distribution of the plurality of target values may be used as a profile representing the uniformity of the degradation of the plurality of batteries.

The diagnosing unit 120 may be configured to determine whether the distribution profile satisfies a predetermined condition and to diagnose the state of the battery pack based on the determination result.

Specifically, the predetermined condition may be a condition for determining whether the distribution profile follows a Gaussian distribution. That is, the predetermined condition may be a condition for determining whether the distribution profile exhibits a shape similar to the Gaussian distribution.

A specific example of how the diagnosing unit 120 determines whether the distribution profile satisfies a predetermined condition is described below with reference to FIGS. 3 and 4.

If the distribution profile does not satisfy a predetermined condition, the diagnosing unit 120 may be configured to diagnose the state of the battery pack as a degradation imbalance state.

Here, the degradation imbalance state refers to a state in which the degradation states of the plurality of batteries included in the battery pack are not uniform. For example, if the degradation states of the plurality of batteries in the battery pack are not uniform, the maximum capacity that may be used for each battery may be different.

On the other hand, the degradation balance state refers to a state in which the degradation states of the plurality of batteries included in the battery pack may be viewed as uniform. For example, even if the degradation states of the plurality of batteries are somewhat different, if the degree of difference is so small that it can be ignored, the state of the battery pack may be diagnosed as a degradation balance state.

As a battery degrades, its available capacity decreases. If the degradation states of a plurality of batteries in a battery pack are non-uniform, the available capacities of the batteries may be different. For example, if the degradation states of a plurality of batteries in a battery pack are non-uniform, the available capacities of the plurality of batteries may not all be the same. In this case, the available capacity of the battery pack may be determined based on the smallest available capacity among the available capacities of the plurality of batteries.

For example, assume that a battery pack includes 5 batteries connected in series, and the available capacity of 4 batteries is 100 [Ah] and the available capacity of 1 battery is 90 [Ah]. In this case, the available capacity of the battery pack is 450 [Ah], not 490 [Ah]. That is, since the degradation of the plurality of batteries is uneven, there is a problem that the capacity for 40 [Ah] cannot be used.

The second distribution profile p2 illustrated in FIG. 4 is an example of a distribution profile that does not satisfy a predetermined condition. The diagnosing unit 120 may diagnose the state of the battery pack corresponding to the second distribution profile p2 as a degradation imbalance state.

If the distribution profile satisfies a predetermined condition, the diagnosing unit 120 may be configured to compare a feature value of the distribution profile with a preset threshold value and diagnose the state of the battery pack based on the comparison result.

The first distribution profile p1 illustrated in FIG. 3 is an example of a distribution profile that satisfies a predetermined condition.

In the embodiment of FIG. 3, the diagnosing unit 120 may compare the feature value of the first distribution profile p1 with a preset threshold value and diagnose the state of the battery pack based on the comparison result.

Here, the feature value means the difference between two target values having the same corresponding number on the distribution profile. The number (Y-axis value) used to determine the feature value may be preset. For example, the feature value may mean the full width at half maximum (FWHM). In this case, the number used to determine the feature value may be preset as half of the maximum number of the distribution profile. As another example, the feature value may mean the maximum difference between two target values having the same corresponding number on the distribution profile. Referring to FIG. 3, the feature value of the first distribution profile p1 may be the difference ($x2 - x1$) between two target values ($x1$, $x2$) having the same corresponding number as k.

The threshold value may be preset based on the BOL (Beginning of Life) state of the battery pack, the current state of the battery pack (e.g. degradation level), a reference value derived from a reference pack corresponding to the battery pack, or a theoretically derived distribution profile. BOL refers to the initial state of the battery, which is the state at which the battery can exhibit maximum capacity and performance at the time of first use after manufacturing.

Specifically, if the feature value exceeds the threshold value, the diagnosing unit 120 may be configured to diagnose the state of the battery pack as a degradation imbalance state. Conversely, if the feature value is less than or equal to the threshold value, the diagnosing unit 120 may be configured to diagnose the state of the battery pack as a degradation balance state.

The battery management apparatus 100 according to the present disclosure has an advantage in that it may diagnose whether a battery pack is in a degradation imbalance state through the distribution of target values representing the degradation states of a plurality of batteries included in the battery pack.

Meanwhile, profile obtaining unit 110 and the diagnosing unit 120 included in the battery management apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the diagnosing unit 120 may be implemented as a set of program modules. At this time, the program module may be stored in the memory and executed by the profile obtaining unit 110 and the diagnosing unit 120. The memory may be inside or outside the battery management apparatus 100 and may be connected to the profile obtaining unit 110 and the diagnosing unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the diagnosing unit 120 are defined.

Specifically, the storage unit 130 may store information required for the profile obtaining unit 110 to obtain a battery profile. The storage unit 130 may store information required for the diagnosing unit 120 to diagnose a state of a battery pack. For example, the storage unit 130 may store a reference positive electrode profile, a reference negative electrode profile, a reference capacity, etc. In addition, the profile obtaining unit 110 and the diagnosing unit 120 may access the storage unit 130 to obtain required information. For example, the first profile and the first target point for a plurality of batteries obtained by the profile obtaining unit 110 may be stored in the storage unit 130, and the diagnosing unit 120 may access the storage unit 130 to obtain the stored plurality of first profiles and plurality of first target points.

According to one embodiment, the diagnosing unit 120 may set a threshold value based on the degradation level of the battery pack and a preset reference feature value. For example, if the diagnosing unit 120 may calculate a value by associating the degradation level of the battery pack and the preset reference feature value, the value can be applied as the threshold value without limitation.

According to one embodiment, the diagnosing unit 120 may set a threshold value by multiplying a degradation level of the battery pack and a preset reference feature value.

The degradation level of a battery pack indicates the degree to which the battery pack has been degraded. In other words, the degradation level of a battery pack indicates the degradation rate of the battery pack. In other words, the degradation level of a battery pack is a concept opposite to the SOH (State of Health) indicating the health state of the battery pack, and may be expressed by the formula $(100 - SOH)$ [%]. Here, the SOH is estimated based on the ratio comparing the current value of the battery pack (e.g., capacity, resistance, etc.) to the initial value, and a conventional SOH estimation method may be applied.

The reference feature value may be preset by considering the BOL state of the battery pack, the feature value of the distribution profile, or the specifications of the battery pack.

For example, the reference feature value may be preset to a specific value considering the specifications of the battery pack. That is, a general value considering the specifications of the battery pack to be diagnosed may be preset as the reference feature value. Meanwhile, a general value considering the specifications of the battery pack may be preset to correspond to the feature value of the battery pack.

As another example, the reference feature value may be preset as a feature value of the reference distribution profile. Here, the reference distribution profile may mean a distribution profile obtained from a reference pack corresponding to the battery pack. Alternatively, the reference distribution profile may mean a distribution profile generated when the battery pack is in a BOL state. The feature value of the reference distribution profile means a difference between two target values having the same corresponding number in the reference distribution profile. According to one embodiment, a criterion for determining the feature value of the reference distribution profile may be the same as a criterion for determining the feature value of the distribution profile. Therefore, the feature value of the reference distribution profile and the feature value of the distribution profile determined according to the same criterion may be corresponding values.

The threshold value may be set by considering the current degradation level of the battery pack. Therefore, the battery management apparatus 100 has the advantage of being able to more accurately diagnose the state of the battery pack based on the reference (threshold value) for the current state of the battery pack.

Below, an embodiment is described in which the diagnosing unit 120 determines whether the distribution profile satisfies a predetermined condition.

The diagnosing unit 120 may be configured to calculate a first value and a second value based on a plurality of target values, and determine whether the distribution profile satisfies a predetermined condition based on a ratio between the first value and the second value.

For example, the diagnosing unit 120 may calculate the first value and the second value based on the minimum value, the maximum value, and the reference value of the plurality of target values. Specifically, the diagnosing unit 120 may determine the minimum value, the maximum value, and the reference value from the plurality of target values. The diagnosing unit 120 may determine the target value with the largest corresponding number from the plurality of target values as the reference value. In addition, the diagnosing unit 120 may be configured to calculate the difference between the minimum value and the reference value as the first value, and to calculate the difference between the reference value and the maximum value as the second value. Finally, the diagnosing unit 120 may determine whether the distribution profile satisfies a predetermined condition based on the ratio between the first value and the second value.

In the embodiment of FIG. 3, the diagnosing unit 120 may determine a1 as a minimum value and a3 as a maximum value among the plurality of target values. Further, the diagnosing unit 120 may determine a2 having a largest corresponding number among the plurality of target values as a reference value. Further, the diagnosing unit 120 may calculate a difference $(a2 - a1)$ between a1 and a2 as a first value, and a difference $(a3 - a2)$ between a2 and a3 as a second value. The diagnosing unit 120 may calculate a ratio "$(a2 - a1) \div (a3 - a2)$" or "$(a3 - a2) \div (a2 - a1)$" between the first value $(a2 - a1)$ and the second value $(a3 - a2)$, and determine whether the distribution profile satisfies a predetermined condition based on the calculation result.

For example, if a1 is 11.1%, a2 is 12.1%, and a3 is 13.1%, the first value is 1% (12.1 - 11.1) and the second value is 1% (13.1 - 12.1). The ratio between the first value and the second value is 1.

In the embodiment of FIG. 4, the diagnosing unit 120 may determine b1 as a minimum value and b3 as a maximum value among the plurality of target values. In addition, the diagnosing unit 120 may determine b2 having the largest corresponding number among the plurality of target values as a reference value. In addition, the diagnosing unit 120 may calculate the difference $(b2 - b1)$ between b1 and b2 as a first value, and calculate the difference $(b3 - b2)$ between b2 and b3 as a second value. The diagnosing unit 120 may calculate "$(b2 - b1) \div (b3 - b2)$" or "$(b3 - b2) \div (b2 - b1)$", which is a ratio between the first value $(b2 - b1)$ and the second value $(b3 - b2)$, and determine whether the distribution profile satisfies a predetermined condition based on the calculation result.

For example, if b1 is 10.1%, b2 is 11.9%, and b3 is 29.2%, the first value is 1.8% (11.9 - 10.1) and the second value is 17.3% (29.2 - 11.9). The ratio between the first value and the second value is 9.61 (17.3 ÷ 1.8) or 0.10 (1.8 ÷ 17.3).

The diagnosing unit 120 may be configured to compare the ratio with a preset threshold ratio section and determine whether the distribution profile satisfies a predetermined condition based on the comparison result.

Specifically, if the calculated ratio belongs to the threshold ratio section, the diagnosing unit 120 may determine that the distribution profile satisfies the predetermined condition. Conversely, if the calculated ratio does not belong to the threshold ratio section, the diagnosing unit 120 may be configured to determine that the distribution profile does not satisfy the predetermined condition.

If the ratio between the first value and the second value is greater than or equal to the lower limit of the threshold ratio section and less than or equal to the upper limit, the diagnosing unit 120 may determine that the calculated ratio belongs to the threshold ratio section. Further, the diagnosing unit 120 may determine that the distribution profile satisfies the predetermined condition. Conversely, if the ratio between the first value and the second value is less than the lower limit or greater than the upper limit, the diagnosing unit 120 may determine that the ratio does not belong to the threshold ratio section. Further, the diagnosing unit 120 may determine that the distribution profile does not satisfy the predetermined condition.

For example, the lower limit of the threshold ratio section may be set to 3 ÷ 7, and the upper limit may be set to 7 ÷ 3. That is, the threshold ratio section may be a preset section to check whether the ratio of the first value and the second value is within 3 : 7 to 7 : 3. Hereinafter, the lower limit of the threshold ratio section is described as 3 ÷ 7, and the upper limit is described as 7 ÷ 3, but it should be noted that the specific numerical values are not limited by the embodiment of the present disclosure.

As in the previous embodiment, it is assumed that the lower limit of the threshold ratio section is set to 3 ÷ 7 and the upper limit is preset to 7 ÷ 3. In this case, in the embodiment of FIG. 3, since the ratio between the first value and the second value (first value (1%) ÷ second value (1%) = 1) is greater than or equal to 3 ÷ 7 and less than or equal to 7 ÷ 3, the diagnosing unit 120 may determine that the ratio belongs to the threshold ratio section. In addition, the diagnosing unit 120 may determine that the first distribution profile p1 satisfies the predetermined condition.

As in the previous embodiment, it is assumed that the lower limit of the threshold ratio section is preset to 3 ÷ 7 and the upper limit is preset to 7 ÷ 3. In this case, in the embodiment of FIG. 4, if the threshold ratio section is preset to be greater than or equal to 3 ÷ 7 and less than or equal to 7 ÷ 3, the ratio between the first value and the second value (first value (17.3%) ÷ second value (1.8%) = 9.61 or first value (1.8%) ÷ second value (17.3%) = 0.10) is less than 3 ÷ 7 or greater than 7 ÷ 3, and therefore, the diagnosing unit 120 may determine that the ratio does not belong to the threshold ratio section. In addition, the diagnosing unit 120 may determine that the second distribution profile p2 does not satisfy the predetermined condition.

Below, an embodiment is described in which the diagnosing unit 120 determines a target value based on the first target point.

In one embodiment, the diagnosing unit 120 may determine the target value based on a reference capacity set for each of a plurality of batteries and a capacity value of the first target point.

For example, the reference capacity may be set based on the positive electrode profile PP. Specifically, the reference capacity may be set to the positive electrode capacity (Qp), which is the difference between the maximum capacity and the minimum capacity of the positive electrode profile PP. As another example, the reference capacity may be set to the negative electrode capacity (Qn), which is the difference between the maximum capacity and the minimum capacity of the negative electrode profile NP. As yet another example, the reference capacity may be set to the battery capacity (Qb), which is the difference between the maximum capacity and the minimum capacity of the battery profile BP. If the reference capacity is a value representing the state of the battery, various values may be applied without being limited to the positive electrode capacity (Qp), the negative electrode capacity (Qn), and the battery capacity (Qb).

The diagnosing unit 120 may calculate the SOC (State of charge) of the first target point based on the ratio of the capacity value of the first target point to the reference capacity, and determine the calculated SOC as the target value. Specifically, the diagnosing unit 120 may calculate the SOC of the first target point by dividing the capacity value of the first target point by the reference capacity, and determine the calculated SOC as the target value. Here, the capacity value of the first target point means a capacity value corresponding to the first target point on the first profile. For example, in the embodiment of FIG. 2, if the first target point is a negative electrode participation end point, the capacity value of the first target point may be the difference between the start capacity (4 [Ah] of FIG. 2) of the first profile NP and the capacity (50 [Ah] of FIG. 2) of the first target point (nf of FIG. 2).

In another embodiment, when the first target point is a positive electrode participation end point, the diagnosing unit 120 may determine the positive electrode loss rate as the target value.

Specifically, the diagnosing unit 120 may calculate the SOC of the first target point based on the ratio of the capacity value of the first target point to the reference capacity, and calculate the positive electrode loss rate based on the first reference value and the second reference value preset for each of the plurality of batteries and the calculated SOC. Then, the diagnosing unit 120 may determine the calculated positive electrode loss rate as the target value. Here, the positive electrode loss rate means the positive electrode reaction area of the battery at the time of diagnosis compared to the positive electrode reaction area of the BOL state battery.

Specifically, the diagnosing unit 120 may calculate the positive electrode loss rate through the following calculation process. The diagnosing unit 120 may calculate the first difference, which is the difference between the first reference value and the second reference value. Then, the diagnosing unit 120 may calculate the second difference, which is the difference between the SOC of the first target point and the first reference value. Finally, the diagnosing unit 120 may calculate the positive electrode loss rate by calculating the ratio of the second difference to the first difference.

Here, the first reference value may be preset to the SOC of the reference participation end point. The SOC of the reference participation end point may be calculated by dividing the capacity value of the reference participation end point by the reference capacity for the battery in the BOL state. The second reference value may be preset to the SOC of the reference participation start point. That is, the SOC of the reference participation start point may be preset to a value obtained by dividing the capacity value of the reference participation start point by the reference capacity for the battery in the BOL state.

For example, the reference participation end point may be the positive electrode participation end point of the positive electrode profile obtained for the battery in the BOL state, and the reference participation start point may be the positive electrode participation start point of the positive electrode profile obtained for the battery in the BOL state.

For example, the diagnosing unit 120 may calculate the positive electrode loss rate using Formula 1 below.

[Formula 1]

$$L_p = \frac{pf_{BOL} - pf_{MOL}}{pf_{BOL} - pi_{BOL}}$$

Here, $L_p$ is the positive electrode loss rate, and $pf_{MOL}$ represents the SOC of the first target point. $pi_{BOL}$

represents the SOC of the positive electrode participation start point of the positive electrode profile acquired for the battery in the BOL state. $pf_{BOL}$ represents the SOC of the positive electrode participation end point of the positive electrode profile obtained for the battery in the BOL state. In addition, MOL (Middle of Life) means a state in which the battery is used to some extent, and it means a stage in which degradation occurs compared to the initial performance (BOL) but normal operation is still maintained.

As another example, the reference participation end point may include a positive electrode participation start point of a positive electrode profile obtained for a battery in the BOL state and a negative electrode participation end point of a negative electrode profile obtained for a battery in the BOL state. The reference participation start point may be a negative electrode participation start point of a negative electrode profile obtained for a battery in the BOL state.

As another example, the diagnosing unit 120 may calculate the positive electrode loss rate using Formula 2 below.

[Formula 2]

$$L_p = \frac{pf_{BOL} - pf_{MOL}}{nf_{BOL} - ni_{BOL}}$$

Here, $L_p$ is the positive electrode loss rate, and $pf_{MOL}$ represents the SOC of the first target point. $pf_{BOL}$ represents the SOC of the positive electrode participation end point of the positive electrode profile acquired for the battery in the BOL state. $nf_{BOL}$ represents the SOC of the negative electrode participation end point of the negative electrode profile obtained for the battery in the BOL state, and $ni_{BOL}$ represents the SOC of the negative electrode participation start point of the negative electrode profile obtained for the battery in the BOL state.

The positive electrode loss rate ($L_p$) calculated using Formula 1 and the positive electrode loss rate ($L_p$) calculated using Formula 2 are the same. This is because "$pf_{BOL} - pi_{BOL}$" and "$nf_{BOL} - ni_{BOL}$" have the same value. For example, in the embodiment of FIG. 2, since the difference between $pf_{BOL}$ and $pi_{BOL}$ and the difference between $ni_{BOL}$ and $nf_{BOL}$ correspond to the capacity ($Qb$) of the battery, the positive electrode loss rate ($L_p$) calculated using Formula 1 and Formula 2 are the same.

Meanwhile, since the positive electrode reaction area decreases as the battery degrades, the positive electrode capacity participating in the charging or discharging reaction may decrease. Therefore, the positive electrode loss rate, which means the positive electrode reaction area of the battery at the time of diagnosis compared to the positive electrode reaction area of the BOL state battery, may be used as an indicator of the degradation level of the battery. In addition, the positive electrode loss rate has a one-to-one correspondence with the SOC of the positive electrode participation end point. This may be confirmed through the positive electrode loss rate calculation process explained above. Therefore, the SOC of the positive electrode participation end point may also be used as an indicator of the degradation level of the battery. In other words, the target value may be used as an indicator of the degradation level of the battery.

In another embodiment, when the first target point is a positive electrode participation start point, the diagnosing unit may determine the available lithium loss rate as the target value.

Specifically, the diagnosing unit 120 may calculate the SOC of the first target point based on a ratio of the capacity value of the first target point to the reference capacity, and calculate the available lithium loss rate based on the first reference value and the second reference value preset for each of the plurality of batteries and the calculated SOC. Then, the diagnosing unit 120 may determine the calculated available lithium loss rate as the target value. Here, the available lithium loss rate means the available lithium of the battery at the time of diagnosis compared to the available lithium of the BOL state battery.

Specifically, the diagnosing unit 120 may calculate the available lithium loss rate through the following calculation process. The diagnosing unit 120 may calculate the first difference, which is the difference between the first reference value and the second reference value. Then, the diagnosing unit 120 may calculate the second difference, which is the difference between the SOC of the first target point and the second reference value. Finally, the diagnosing unit 120 may calculate the available lithium loss rate by calculating the ratio of the second difference to the first difference.

Here, the first reference value may be preset to the SOC of the reference participation end point. The SOC of the reference participation end point may be calculated by dividing the capacity value of the reference participation end point by the reference capacity for the battery in the BOL state. The second reference value may be preset to the SOC of the reference participation start point. That is, the SOC of the reference participation start point may be preset to a value obtained by dividing the capacity value of the reference participation start point by the reference capacity for the battery in the BOL state.

For example, the reference participation end point may be the positive electrode participation end point of the positive electrode profile obtained for the battery in the BOL state, and the reference participation start point may be the positive electrode participation start point of the positive electrode profile obtained for the battery in the BOL state.

For example, the diagnosing unit 120 may calculate the available lithium loss rate using Formula 3 below.

[Formula 3]

$$L_{Li} = \frac{pi_{MOL} - pi_{BOL}}{pf_{BOL} - pi_{BOL}}$$

Here, $L_{Li}$ is the available lithium loss rate, and $pi_{MOL}$ represents the SOC of the first target point. $pi_{BOL}$ represents the SOC of the positive electrode participation start point of the positive electrode profile obtained for the battery in the BOL state, and $pf_{BOL}$ represents the SOC of the positive electrode participation end point of the positive electrode profile obtained for the battery in the BOL state.

As another example, the reference participation end point may be a negative electrode participation end point of a negative electrode profile obtained for a battery in the BOL state, and the reference participation start point may include a negative electrode participation start point of a negative electrode profile obtained for a battery in the BOL state and a positive electrode participation start point of a positive electrode profile obtained for a battery in the BOL state.

For example, the diagnosing unit 120 may calculate the available lithium loss rate using Formula 4 below.

[Formula 4]

$$L_{Li} = \frac{pi_{MOL} - pi_{BOL}}{nf_{BOL} - ni_{BOL}}$$

Here, $L_{Li}$ is the available lithium loss rate, $pi_{MOL}$ represents the SOC of the first target point, $pi_{BOL}$ represents the SOC of the positive electrode participation start point of the positive electrode profile obtained for the battery in the BOL state, $nf_{BOL}$ represents the SOC of the negative electrode participation end point of the negative electrode profile obtained for the battery in the BOL state, and $ni_{BOL}$ represents the SOC of the negative electrode participation start point of the negative electrode profile obtained for the battery in the BOL state.

Preferably, the available lithium loss rate ($L_{Li}$) calculated using Formula 3 and the available lithium loss rate ($L_{Li}$) calculated using Formula 4 are the same. This is because "$pf_{BOL} - pi_{BOL}$" and "$nf_{BOL} - ni_{BOL}$" have the same value. For example, in the embodiment of FIG. 2, since the difference between $pf_{BOL}$ and $pi_{BOL}$ and the difference between $nf_{BOL}$ and $ni_{BOL}$ correspond to the capacity (Qb) of the battery, the available lithium loss rates ($L_{Li}$) calculated using Formula 3 and Formula 4 are the same.

Meanwhile, as the battery degrades, the amount of available lithium that can move between the positive electrode and the negative electrode during charge and discharge gradually decreases. For example, as the battery degrades, a lithium plating (Li-plating) phenomenon may occur in which lithium is deposited on the surface of the negative electrode. If the lithium plating phenomenon occurs, the amount of available lithium decreases as much as lithium deposited on the surface of the negative electrode. Therefore, the available lithium loss rate may be used as an indicator of the degradation level of the battery. In addition, the available lithium loss rate has a one-to-one correspondence with the SOC of the positive electrode participation start point. This may be confirmed through the available lithium loss rate calculation process described above. Therefore, the SOC of the positive electrode participation start point may also be used as an indicator of the degradation level of the battery. In other words, the target value may be used as an indicator of the degradation level of the battery.

The above describes an example of calculating the SOC of the first target point as a target value. However, the target value is not limited to the SOC of the first target point, and may be applied in various ways as long as it is a value that can specify the first target point. For example, the capacity value or voltage value of the first target point may also be applied as a target value.

Below, an embodiment in which the diagnosing unit 120 determines a target value based on the target ratio is described.

In one embodiment, the diagnosing unit may determine the target ratio as the target value.

For example, when the first profile is a positive electrode profile, the target ratio is a positive electrode change ratio. In this case, the diagnosing unit 120 may be configured to calculate the change ratio of the first profile with respect to the reference positive electrode profile Rp as the target ratio. That is, the diagnosing unit 120 may calculate the change ratio of the positive electrode profile PP with respect to the reference positive electrode profile Rp as the target ratio. For example, the diagnosing unit 120 may determine the target ratio as the target value. That is, the diagnosing unit 120 may determine the positive electrode change ratio as the target value.

As another example, when the first profile is a negative electrode profile, the target ratio is a negative electrode change ratio. In this case, the diagnosing unit 120 may be configured to calculate the change ratio of the first profile with respect to the reference negative electrode profile Rn as the target ratio. That is, the diagnosing unit 120 may calculate the change ratio of the negative electrode profile NP with respect to the reference negative electrode profile Rn as the target ratio. For example, the diagnosing unit 120 may determine the target ratio as the target value. That is, the diagnosing unit 120 may determine the negative electrode change ratio as the target value.

In another embodiment, when the target ratio is a positive electrode change ratio, the diagnosing unit 120 may determine a positive electrode loss rate as the target value. Specifically, the diagnosing unit 120 may calculate a positive electrode loss rate based on a ratio between a preset reference ratio and the target ratio for each of the plurality of batteries, and determine the calculated positive electrode loss rate as the target value.

Here, the reference ratio is the positive electrode change ratio corresponding to the battery in the BOL state. Specifically, the reference ratio is the ratio of the positive electrode profile corresponding to the battery profile for the battery in the BOL state, which is changed compared to the reference positive electrode profile Rp. In addition, the positive electrode loss rate means the positive electrode reaction area of the battery at the time of diagnosis compared to the positive electrode reaction area of the battery in the BOL state.

Specifically, the diagnosing unit 120 may calculate the positive electrode loss rate through the following calculation process. The diagnosing unit 120 may calculate the positive electrode loss rate based on the value obtained by dividing the target ratio by the reference ratio.

For example, diagnosing unit 120 may calculate the positive electrode loss rate using Formula 5 below.

[Formula 5]

$$L_p = 1 - \frac{ps_{MOL}}{ps_{BOL}}$$

Here, $L_p$ represents the positive electrode loss rate, $ps_{MOL}$ represents the target ratio (positive electrode change ratio), and $ps_{BOL}$ represents the reference ratio.

Meanwhile, since the positive electrode reaction area decreases as the battery degrades, the positive electrode capacity participating in the reaction during charging or discharging may decrease. Therefore, the positive electrode loss rate, which means the positive electrode reaction area of the battery at the time of diagnosis compared to the positive electrode reaction area of the BOL state battery, may be used as an indicator of the degradation level of the battery. In addition, the positive electrode loss rate has a one-to-one correspondence with the positive electrode change ratio. This may be confirmed through the positive electrode loss rate calculation process explained above. Therefore, the positive electrode change ratio may also be used as an indicator of the degradation level of the battery. That is, the target value may be used as an indicator of the degradation level of the battery.

In another embodiment, when the target ratio is a negative electrode change ratio, the diagnosing unit 120 may determine a negative electrode loss rate as the target value. Specifically, the diagnosing unit 120 may calculate a negative electrode loss rate based on a ratio between a preset reference ratio and the target ratio for each of the plurality of batteries, and determine the calculated negative electrode loss rate as the target value.

Here, the reference ratio is the negative electrode change ratio corresponding to the battery in the BOL state. Specifically, the reference ratio is the ratio of the negative electrode profile corresponding to the battery profile for the battery in the BOL state, which is changed compared to the reference negative electrode profile Rn. In addition, the negative electrode loss rate means the negative electrode reaction area of the battery at the time of diagnosis compared to the negative electrode reaction area of the battery in the BOL state.

Specifically, the diagnosing unit 120 may calculate the negative electrode loss rate through the following calculation process. The diagnosing unit 120 may calculate the negative electrode loss rate based on the value obtained by dividing the target ratio by the reference ratio.

For example, the diagnosing unit 120 may calculate the negative electrode loss rate using Formula 6 below.

[Formula 6]

$$L_n = 1 - \frac{ns_{MOL}}{ns_{BOL}}$$

Here, $L_n$ represents the negative electrode loss rate, $ns_{MOL}$ represents the target ratio, and $ns_{BOL}$ represents the reference ratio.

Meanwhile, since the negative electrode reaction area decreases as the battery degrades, the negative electrode capacity participating in the reaction during charging or discharging may decrease. Therefore, the negative electrode loss rate, which means the negative electrode reaction area of the battery at the time of diagnosis compared to the negative electrode reaction area of the BOL state battery, may be used as an indicator of the degradation level of the battery. In addition, the negative electrode loss rate has a one-to-one correspondence with the negative electrode change ratio. This may be confirmed through the negative electrode loss rate calculation process explained above. Therefore, the negative electrode change ratio may also be used as an indicator of the degradation level of the battery. That is, the target value may be used as an indicator of the degradation level of the battery.

Below, a specific embodiment in which the diagnosing unit 120 determines a target value based on the first target point and the second target point is described.

In one embodiment, the diagnosing unit may be configured to determine a target value based on a reference capacity set for each of the plurality of batteries, a first target point, and a second target point included in each of the plurality of first profiles.

Here, if the first profile is a positive electrode profile, the second target point may be different from the first target point among the positive electrode participation start point and the positive electrode participation end point. For example, if the first target point is a positive electrode participation start point, the second target point is a positive electrode participation end point. In another example, if the first target point is a positive electrode participation end point, the second target point is a positive electrode participation start point.

If the first profile is a negative electrode profile, the second target point may be different from the first target point among the negative electrode participation start point and the negative electrode participation end point. For example, if the first target point is the negative electrode participation start point, the second target point is the negative electrode participation end point. In another example, if the first target point is the negative electrode participation end point, the second target point is the negative electrode participation start point.

The diagnosing unit 120 may be configured to determine a target value based on the reference capacity set for each of the plurality of batteries, the first target point, and the second target point.

As explained above, the reference capacity may be set to the positive electrode capacity (Qp), the negative electrode capacity (Qn), or the battery capacity (Qb). If the reference capacity is a value representing the state of the battery, various values may be applied, not limited to the positive electrode capacity (Qp), the negative electrode capacity (Qn), and the battery capacity (Qb).

For example, the diagnosing unit 120 may calculate the SOC of the second target point based on the ratio of the capacity value of the second target point to the reference capacity, and determine the SOC of the second target point as the target value.

Specifically, the diagnosing unit 120 may calculate the SOC of the second target point by dividing the capacity value of the second target point by the reference capacity, and determine the calculated SOC as the target value. Here, the capacity value of the second target point means the capacity value corresponding to the second target point on the first profile. For example, in the embodiment of FIG. 2, the capacity value of the second target point may be the difference between the start capacity (4 [Ah] of FIG. 2) of the first profile NP and the capacity (5 [Ah] of FIG. 2) of the second target point (ni of FIG. 2).

As another example, the diagnosing unit 120 may be configured to calculate the SOC of the first target point based on a ratio of the capacity value of the first target point to the reference capacity, calculate the SOC of the second target point based on a ratio of the capacity value of the second target point to the reference capacity, calculate a capacity loss rate based on the first reference value and the second reference value preset for each of the plurality of batteries, the SOC of the first target point, and the SOC of the second target point, and determine the calculated capacity loss rate as the target value.

Specifically, the diagnosing unit 120 may calculate the capacity loss rate through the following calculation process. The diagnosing unit 120 may calculate the first difference, which is the difference between the first reference value and the second reference value. Then, the diagnosing unit 120 may calculate the third difference, which is the difference between the SOC of the first target point and the SOC of the second target point. Finally, the diagnosing unit 120 may calculate the capacity loss rate by calculating the ratio of the third difference to the first difference.

Here, the first reference value may be preset to the SOC of the reference participation end point. The SOC of the reference participation end point may be calculated by dividing the capacity value of the reference participation end point by the reference capacity for the battery in the BOL state. The second reference value may be preset to the SOC of the reference participation start point. That is, the SOC of the reference participation start point may be preset to a value obtained by dividing the capacity value of the reference participation start point by the reference capacity for the battery in the BOL state.

In one embodiment, the reference participation end point may be a positive electrode participation end point of the positive electrode profile obtained for the battery in the BOL state, and the reference participation start point may be a positive electrode participation start point of the positive electrode profile obtained for the battery in the BOL state.

For example, diagnosing unit 120 may calculate the capacity loss rate using Formula 7 below.

[Formula 7]

$$L_Q = 1 - \frac{pf_{MOL} - pi_{MOL}}{pf_{BOL} - pi_{BOL}}$$

Here, $L_Q$ is the capacity loss rate, $pf_{MOL}$ represents the SOC of the second target point, $pi_{MOL}$ represents the SOC of the first target point, $pi_{BOL}$ represents the SOC of the positive electrode participation start point of the positive electrode profile obtained for the battery in the BOL state, and $pf_{BOL}$ represents the SOC of the positive electrode participation end point of the positive electrode profile obtained for the battery in the BOL state.

As another example, the diagnosing unit 120 may calculate the capacity loss rate using Formula 8 below.

[Formula 8]

$$L_Q = 1 - \frac{nf_{MOL} - ni_{MOL}}{pf_{BOL} - pi_{BOL}}$$

Here, $L_Q$ is the capacity loss rate, $nf_{MOL}$ represents the SOC of the first target point, and $ni_{MOL}$ represents the SOC of the second target point. $pi_{BOL}$ represents the SOC of the positive electrode participation start point of the positive electrode profile obtained for the battery in the BOL state, and $pf_{BOL}$ represents the SOC of the positive electrode participation end point of the positive electrode profile obtained for the battery in the BOL state.

In another embodiment, the reference participation end point may be a negative electrode participation end point of the negative electrode profile obtained for the battery in the BOL state, and the reference participation start point may be a negative electrode participation start point of the negative electrode profile obtained for the battery in the BOL state.

For example, the diagnosing unit 120 may calculate the capacity loss rate using Formula 9 below.

[Formula 9]

$$L_Q = 1 - \frac{pf_{MOL} - pi_{MOL}}{nf_{BOL} - ni_{BOL}}$$

Here, $L_Q$ is the capacity loss rate, $pf_{MOL}$ represents the SOC of the second target point, $pi_{MOL}$ represents the SOC of the first target point, $nf_{BOL}$ represents the SOC of the negative electrode participation end point of the negative electrode profile obtained for the battery in the BOL state, and $ni_{BOL}$ represents the SOC of the negative electrode participation start point of the negative electrode profile obtained for the battery in the BOL state.

As another example, the diagnosing unit 120 may calculate the capacity loss rate using Formula 10 below.

[Formula 10]

$$L_Q = 1 - \frac{nf_{MOL} - ni_{MOL}}{nf_{BOL} - ni_{BOL}}$$

Here, $L_Q$ is the capacity loss rate, $nf_{MOL}$ represents the SOC of the second target point, and $ni_{MOL}$ represents the SOC of the first target point. $nf_{BOL}$ represents the SOC of the negative electrode participation end point of the negative electrode profile obtained for the battery in the BOL state, and $ni_{BOL}$ represents the SOC of the negative electrode participation start point of the negative electrode profile obtained for the battery in the BOL state.

Preferably, the capacity loss rates ($L_Q$) calculated using each of Formula 7 to Formula 10 are all the same. This is because "$pf_{BOL}$ - $pi_{BOL}$" and "$nf_{BOL}$ - $ni_{BOL}$" have the same value, and "$pf_{MOL}$ - $pi_{MOL}$" and "$nf_{MOL}$ - $ni_{MOL}$" have the same value.

Hereinafter, an example is described in which the profile obtaining unit 110 determines the positive electrode profile PP and the negative electrode profile NP.

FIG. 5 is a drawing schematically illustrating a reference positive electrode profile Rp and a reference negative electrode profile Rn according to an embodiment of the present disclosure. In the embodiment of FIG. 5, the horizontal axis (X-axis) represents capacity (Ah) and the vertical axis (Y-axis) represents voltage (V).

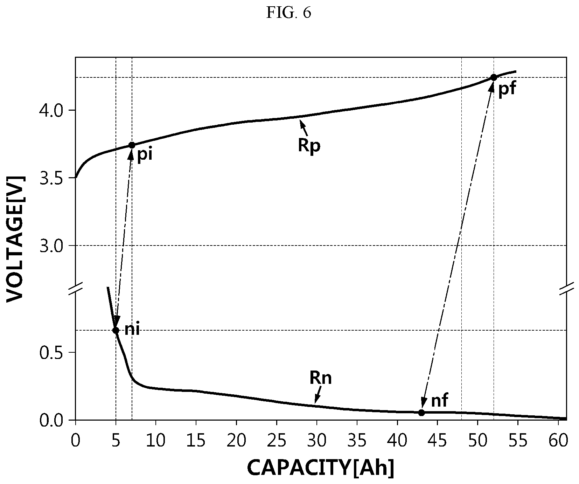

FIG. 6 to FIG. 8 are drawings for reference in explaining an example of a procedure for generating a comparative profile S used for comparison with a battery profile BP according to an embodiment of the present disclosure.

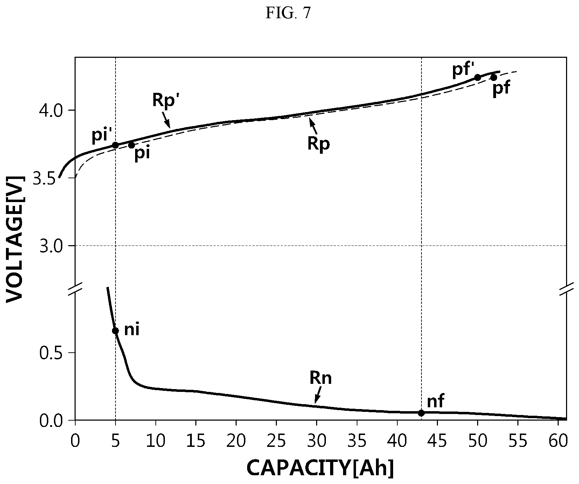

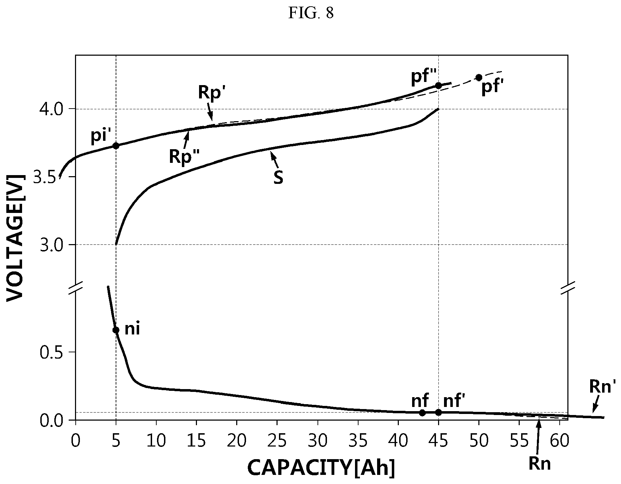

The procedure of generating a comparative profile S, which will be described with reference to FIGS. 6 to 8, proceeds in the following order: a first routine that sets four points (positive electrode participation start point pi, positive electrode participation end point pf, negative electrode participation start point ni, negative electrode participation end point nf) to correspond to the voltage range of interest (see FIG. 6), a second routine that performs profile shift (see FIG. 7), and a third routine that performs capacity scaling (see FIG. 8). In other words, the procedure for generating a comparative profile S according to an embodiment of the present disclosure includes first to third routines.

Here, the positive electrode participation start point pi means a positive electrode point where the reaction starts during the charging process or a positive electrode point where the reaction ends during the discharging process. The positive electrode participation end point pf means a positive electrode point where the reaction ends during the charging process or a positive electrode point where the reaction starts during the discharging process. In addition, the negative electrode participation start point ni means a negative electrode point where the reaction starts during the charging process or a negative electrode point where the reaction ends during the discharging process. The negative electrode participation end point nf means a negative electrode point where the reaction ends during the charging process or a negative electrode point where the reaction starts during the discharging process.

First, referring to FIG. 6, the reference positive electrode profile Rp and the reference negative electrode profile Rn are the same as those shown in FIG. 5.

The profile obtaining unit 110 determines a positive electrode participation start point pi, a positive electrode participation end point pf, a negative electrode participation start point ni, and a negative electrode participation end point nf on the reference positive electrode profile Rp and the reference negative electrode profile Rn.

Either the positive electrode participation start point pi or the negative electrode participation start point ni depends on the other.

Preferably, the difference between the voltage of the positive electrode participation start point pi and the voltage of the negative electrode participation start point ni may be set equal to the start voltage (minimum voltage) of the battery profile BP.

As an example, the profile obtaining unit 110 may divide the positive electrode voltage range from the start point of the reference positive electrode profile Rp to the end point into a plurality of micro voltage sections, and then set the boundary point of the two adjacent micro voltage sections among the plurality of micro voltage sections to the positive electrode participation start point pi. Each micro voltage section may have a predetermined size (e.g., 0.01 V). Next, the profile obtaining unit 110 may set a point, which exists on the reference negative electrode profile Rn and is smaller than the voltage of the positive electrode participation start point pi by the first set voltage (e.g., 3 V), as the negative electrode participation start point ni.

As another example, the profile obtaining unit 110 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections to the negative electrode participation start point ni. Next, the profile obtaining unit 110 may set a point, which exists on the reference positive electrode profile Rp and is greater than the voltage of the negative electrode participation start point ni by the first set voltage, as the positive electrode participation start point pi.

Either positive electrode participation end point pf or negative electrode participation end point nf depends on the other.

Preferably, the difference between the voltage of the positive electrode participation end point pf and the voltage of the negative electrode participation end point nf may be set equal to the end voltage (maximum voltage) of the battery profile BP.

As an example, the profile obtaining unit 110 may divide the positive electrode voltage range from the second set voltage to the end point of the reference positive electrode profile Rp into a plurality of micro voltage sections of a predetermined size, and then set the boundary point of two adjacent micro voltage sections among the plurality of micro voltage sections to the positive electrode participation end point pf. Next, the profile obtaining unit 110 may set a point, which exists on the reference negative electrode profile Rn and is smaller than the voltage of the positive electrode participation end point pf by the second set voltage (e.g., 4 V) as the negative electrode participation end point nf.

As another example, the profile obtaining unit 110 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections to the negative electrode participation end point nf. Next, the profile obtaining unit 110 may set a point, which exists on the reference positive electrode profile Rp and is greater than the negative electrode participation end point nf by the second set voltage, as the positive electrode participation end point pf.

Once the determination of the positive electrode participation start point pi, the positive electrode participation end point pf, the negative electrode participation start point ni, and the negative electrode participation end point nf is completed, the profile obtaining unit 110 shifts at least one of the reference positive electrode profile Rp and the reference negative electrode profile Rn to the left or right along the horizontal axis.

Preferably, the difference between the capacity value of the positive electrode participation start point pi and the capacity value of the positive electrode participation end point pf, the difference between the capacity value of the negative electrode participation start point ni and the capacity value of the negative electrode participation end point nf, and the difference between the start capacity of the battery profile BP and the end capacity of the battery profile BP may be set to be the same.

Referring to FIG. 7, for example, the profile obtaining unit 110 may shift the reference positive electrode profile Rp to the left (toward low capacity) or shift the negative electrode profile Rn to the right (toward high capacity), or both, so that the capacity values of the positive electrode participation start point pi and the negative electrode participation start point ni match.

As another example, the profile obtaining unit 110 may shift the reference positive electrode profile Rp to the left, or shift the reference negative electrode profile Rn to the right, or both, so that the capacity values of the positive electrode participation end point pf and the negative electrode participation end point nf match.

FIG. 7 illustrates a situation where the capacity value of the positive electrode participation start point pi' matches the capacity value of the negative electrode participation start point ni as a result of generating an adjusted positive electrode profile Rp' by shifting only the reference positive electrode profile Rp to the left. The adjusted positive electrode profile Rp' is the result of applying an adjustment procedure, which shifts to the left by the capacity value difference between the positive electrode participation start point pi and the negative electrode participation start point ni, to the reference positive electrode profile Rp. Therefore, the two points pi, pi' differ only in capacity values and have the same voltage. The two points pf, pf' differ only in capacity values and have the same voltage.

When the adjustment result profiles Rp', Rn in which at least one of the reference positive electrode profile Rp and the reference negative electrode profile Rn is shifted are secured, the profile obtaining unit 110 scales the capacity range of at least one of the adjustment result profiles Rp', Rn.

Preferably, the capacity scaling may be performed so that the capacity range between the positive electrode participation start point and the positive electrode participation end point of the adjusted positive electrode profile Rp', the capacity range between the negative electrode participation start point and the negative electrode participation end point of the adjusted negative electrode profile Rn', and the capacity range of the battery profile BP are the same.

According to the example shown in FIG. 8, the profile obtaining unit 110 performs an additional adjustment procedure to contract or expand at least one of the adjusted positive electrode profile Rp' and the reference negative electrode profile Rn along the horizontal axis. That is, the capacity range may be shrunken or expanded while keeping the voltage range of the adjusted positive electrode profile Rp' constant. Alternatively, the capacity range may be shrunken or expanded while keeping the voltage range of the reference negative electrode profile Rn constant.

Referring to FIG. 8, the profile obtaining unit 110 may generate an adjusted positive electrode profile Rp'' by shrinking or expanding the adjusted positive electrode profile Rp' so that the capacity range between two points pi', pf' of the adjusted positive electrode profile Rp' matches the capacity range of the battery profile BP. At this time, one point pi' of the two points pi', pf' may be fixed. Accordingly, the capacity range between the two points pi', pf'' of the adjusted positive electrode profile Rp'' may match the capacity range of the battery profile BP.

In addition, the profile obtaining unit 110 may generate an adjusted negative electrode profile Rn' by shrinking or expanding the reference negative electrode profile Rn so that the capacity range between the two points ni, nf of the reference negative electrode profile Rn also matches the capacity range of the battery profile BP. At this time, one point ni of the two points ni, nf may be fixed. Accordingly, the capacity range between the two points ni, nf' of the adjusted negative electrode profile Rn' may match the capacity range of the battery profile BP.

In FIG. 8, the adjusted positive electrode profile Rp'' is the result of shrinkage of the adjusted positive electrode profile Rp' shown in FIG. 7 along the capacity axis, and the adjusted negative electrode profile Rn' is the result of expanding of the reference negative electrode profile Rn shown in FIG. 6 along the capacity axis.

The positive electrode participation end point pf'' on the adjusted positive electrode profile Rp'' corresponds to the positive electrode participation end point pf' on the adjusted positive electrode profile Rp'. The negative electrode participation end point nf' on the adjusted negative electrode profile Rn' corresponds to the negative electrode participation end point nf on the reference negative electrode profile Rn.

The capacity range between the positive electrode participation start point pi' and the positive electrode participation end point pf'' of the adjusted positive electrode profile Rp'' matches the capacity range of the battery profile BP. Likewise, the capacity range between the negative electrode participation start point ni and the negative electrode participation end point nf' of the adjusted negative electrode profile Rn' matches the capacity range of the battery profile BP.

In addition, the capacity range between the two points pi', pf'' of the adjusted positive electrode profile Rp'' matches the capacity range between the two points ni, nf' of the adjusted negative electrode profile Rn'. The profile obtaining unit 110 may generate a comparative profile S by subtracting the profile between two points pi', pf' of the adjusted positive electrode profile Rp'' from the profile between two points ni, nf' of the adjusted negative electrode profile Rn'.

The profile obtaining unit 110 may calculate the error (profile error) between the comparative profile S and the battery profile BP.

In relation to this, various methods known at the time of filing the present disclosure may be employed to determine the error between two profiles, each of which can be expressed in a two-dimensional coordinate system. For example, the integral value of the absolute value of the area between two profiles or RMSE (Root Mean Square Error) may be used as the error between the two profiles.

The profile obtaining unit 110 may map at least two of the adjusted positive electrode profile Rp'', the adjusted negative electrode profile Rn', the positive electrode participation start point pi', the positive electrode participation end point pf'', the negative electrode participation start point ni, the negative electrode participation end point nf', the first scale factor, the second scale factor, the comparative profile S, and the profile error with each other and record in the storage unit 130. The first scale factor may represent the ratio of the capacity difference between two points pi', pf'' to the capacity difference between the two points pi0, pf0. The second scale factor may represent the ratio of the capacity difference between two points ni, nf' to the capacity difference between two points ni0, nf0.

The profile obtaining unit 110 may calculate the positive electrode change ratio ps based on the reference positive electrode profile Rp and the adjusted positive electrode profile Rp''. Here, the positive electrode change ratio ps means the ratio of the adjusted positive electrode profile changed with respect to the reference positive electrode profile. Additionally, the profile obtaining unit 110 may calculate the negative electrode change ratio ns based on the reference negative electrode profile Rn and the adjusted negative electrode profile Rn'. Here, the negative electrode change ratio ns means the ratio of the adjusted negative electrode profile changed with respect to the reference negative electrode profile.

For example, the profile obtaining unit 110 may determine the first scale factor as the positive electrode change ratio ps and determine the second scale factor as the negative electrode change ratio ns.

As described above, when the positive electrode voltage range of the reference positive electrode profile Rp is divided into a plurality of micro voltage sections, the boundary point of two adjacent micro voltage sections among the plurality of micro voltage sections may be set to the positive electrode participation start point pi.

For example, if the positive electrode voltage range of the reference positive electrode profile Rp is divided into 100 micro voltage ranges, there may be 100 boundary points that can be set as the positive electrode participation start point pi. Additionally, if the voltage range greater than or equal to the second set voltage in the reference positive electrode profile Rp is divided into 40 micro voltage ranges, there may be 40 boundary points that can be set as the positive electrode participation end point pf. In this case, up to 4000 different comparative profiles can be generated.

Of course, it will be easy to understand that as the size of the micro voltage section decreases, the number of comparative profiles that can be maximally generated increases, and conversely, as the size of the micro voltage section increases, the number of comparative profiles that can be maximally generated decreases.

The profile obtaining unit 110 may identify a minimum value among the profile errors of the plurality of comparative profiles generated as described above, and then obtain the information mapped to the minimum profile error (e.g., at least one of the positive electrode participation start point, the positive electrode participation end point, the negative electrode participation start point, the negative electrode participation end point, the first scale factor, and the second scale factor) from the storage unit 130.

If the comparative profile S shown in FIG. 8 has the minimum profile error to the battery profile BP, the adjusted positive electrode profile Rp" may be used as the positive electrode profile PP, and the adjusted negative electrode profile Rn' may be used as the negative electrode profile NP.

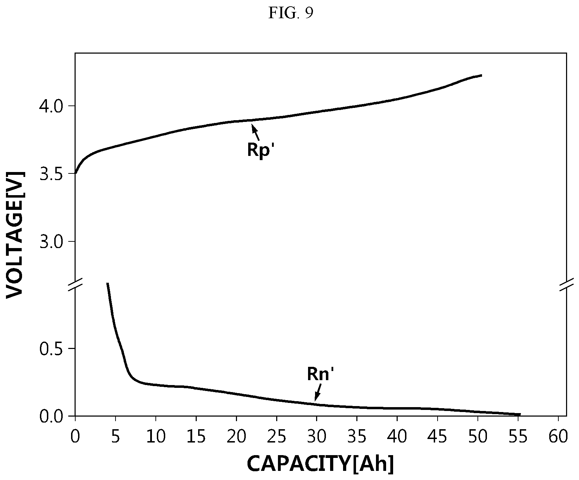

FIG. 9 to FIG. 11 are drawings for reference in explaining another example of a procedure for generating a comparative profile U used for comparison with a battery profile BP according to an embodiment of the present disclosure. For reference, the embodiment according to FIGS. 9 to 11 is independent from the embodiment according to FIGS. 6 to 8. Accordingly, terms or symbols commonly used in describing the embodiments shown in FIGS. 6 to 8 and the embodiments shown in FIGS. 9 to 11 should be understood as being limited to each embodiment.

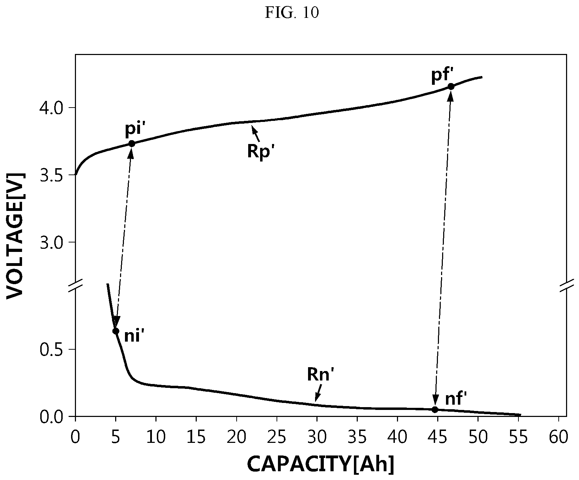

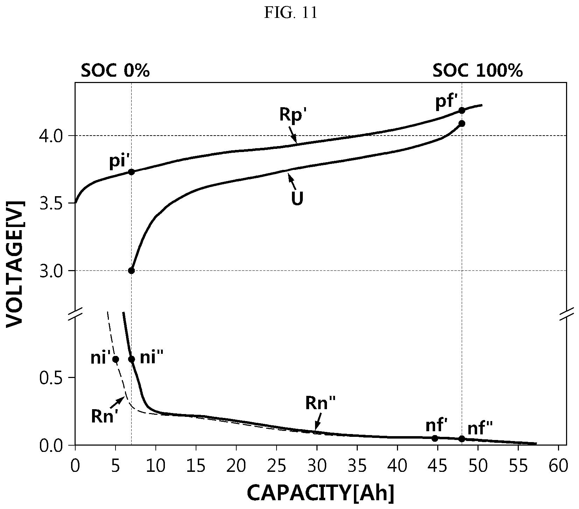

The procedure of generating the comparative profile U to be described with reference to FIGS. 9 to 11 includes a fourth routine that performs capacity scaling (see FIG. 9), a fifth routine that sets four points (positive electrode participation start point, positive electrode participation end point, negative electrode participation start point, negative electrode participation end point) (see FIG. 10), and a sixth routine that performs profile shift (see FIG. 11). That is, the procedure of generating the comparative profile U according to another embodiment of the present disclosure includes the fourth to sixth routines.

The reference positive electrode profile Rp and the reference negative electrode profile Rn for the embodiment according to FIGS. 9 to 11 are the same as those shown in FIG. 5.

The profile obtaining unit 110 generates an adjusted positive electrode profile Rp' and an adjusted negative electrode profile Rn' by applying the first scale factor and the second scale factor selected from the scaling value range to the reference positive electrode profile Rp and the reference negative electrode profile Rn, respectively.

The scaling value range may be predetermined or may vary depending on the ratio of the size of the capacity range of the battery profile BP to the size of the capacity range of the reference profile R. As an example, when it is possible to select the first scale factor and the second scale factor among the values spaced at 0.1% intervals (i.e., 90%, 90.1%, 90.2%, ..., 98.9%, 99%) of the scaling value range (e.g., 90 to 99), 91 values can be selected as the first scale factor and the second scale factor, respectively. In this case, up to 8,281 adjusted profile pairs can be generated according to $91 \times 91 = 8,281$ adjustment levels (combination of the first scale factor and the second scale factor). The adjusted profile pair refers to a combination of the adjusted positive electrode profile and the adjusted negative electrode profile.

The adjusted positive electrode profile Rp' and the adjusted negative electrode profile Rn' shown in FIG. 9 show an example of the results of applying the first scale factor and the second scale factor of less than 100% to the reference positive electrode profile Rp and the reference negative electrode profile Rn, respectively.

Since the first scale factor and the second scale factor are less than 100%, the adjusted positive electrode profile Rp' is a contraction of the reference positive electrode profile Rp along the horizontal axis, and the adjusted negative electrode profile Rn' is also a contraction of the reference negative electrode profile Rn along the horizontal axis. To facilitate understanding, the drawings are illustrated as a form in which the starting point of each of the positive electrode profile Rp and the reference negative electrode profile Rn is fixed and the remaining portions are reduced to the left along the horizontal axis.

Referring to FIG. 10, the profile obtaining unit 110 determines the positive electrode participation start point pi', the positive electrode participation end point pf', the negative electrode participation start point ni', and the negative electrode participation end point nf' on the adjusted positive electrode profile Rp' and the adjusted negative electrode profile Rn'.

Either positive electrode participation start point pi' or negative electrode participation start point ni' may depend on the other. Additionally, either positive electrode participation end point pf' or negative electrode participation end point nf' may depend on the other. Additionally, either positive electrode participation start point pi' or positive electrode participation end point pf' may be set based on the other.

That is, when any one of the positive electrode participation start point pi', the positive electrode participation end point pf', the negative electrode participation start point ni', and the negative electrode participation end point nf' is set, the remaining three points may be set automatically by the first set voltage, the second set voltage and/or the size of the capacity range of the battery profile BP (e.g. charging capacity of SOC 0 to 100%).

As an example, the profile obtaining unit 110 may divide the positive electrode voltage range from the start point of the adjusted positive electrode profile Rp' to the end point (or second set voltage) into a plurality of micro voltage section, and then set the boundary point of two adjacent micro voltage sections among the plurality of micro voltage sections to the positive electrode participation start point pi'. Next, the profile obtaining unit 110 may set a point, which exists on the adjusted negative electrode profile Rn' and is smaller than the voltage of the positive electrode participation start point pi' by the first set voltage (e.g., 3 V), as the negative electrode participation start point ni'.

As another example, the profile obtaining unit 110 may divide the negative electrode voltage range from the start point to the end point of the adjusted negative electrode profile Rn' into a plurality of micro voltage sections of a predetermined size, and then set the boundary point of two adjacent micro voltage sections among the plurality of micro voltage sections to the negative electrode participation start point ni'. Next, the profile obtaining unit 110 may search for a point, which exists on the adjusted positive electrode profile Rp' and is greater than the voltage of the negative electrode participation start point ni' by the first set voltage, as the positive electrode participation start point pi'.

As still another example, the profile obtaining unit 110 may divide the voltage range from the second set voltage to the end point of the adjusted positive electrode profile Rp' into a plurality of micro voltage sections of a predetermined size, and then set the boundary point of two adjacent micro voltage sections among the plurality of micro voltage sections to the positive electrode participation end point pf. Next, the profile obtaining unit 110 may set a point, which exists on the adjusted negative electrode profile Rn' and is smaller than the voltage of the positive electrode participation end point pf' by the second set voltage (e.g., 4 V), as the negative electrode participation end point nf'.

As still another example, the profile obtaining unit 110 may divide the negative electrode voltage range from the start point to the end point of the adjusted negative electrode profile Rn' into a plurality of micro voltage sections of a predetermined size, and then set the boundary point of two adjacent micro voltage sections among the plurality of micro voltage sections to the negative electrode participation end point nf'. Next, the profile obtaining unit 110 may set a point, which exists on the adjusted positive electrode profile Rp' and is greater than the voltage of the negative electrode participation end point nf' by the second set voltage, as positive electrode participation end point pf'.

When any one of the positive electrode participation start point pi', the positive electrode participation end point pf', the negative electrode participation start point ni', and the negative electrode participation end point nf' is determined, the profile obtaining unit 110 may additionally determine the remaining three points based on the determined point.

As an example, when the positive electrode participation start point pi' is determined first, the profile obtaining unit 110 may set a point on the adjusted positive electrode profile Rp', which has a capacity value larger than the capacity value of the positive electrode participation start point pi' by the size of the capacity range of the battery profile BP, as the positive electrode participation end point pf. In addition, the profile obtaining unit 110 may search for a point lower than the voltage of the positive electrode participation start point pi' by the first set voltage from the adjusted negative electrode profile Rn' and set the searched point as the negative electrode participation start point ni'. In addition, the profile obtaining unit 110 may set a point on the adjusted negative electrode profile Rn', which has a capacity value greater than the capacity value of the negative electrode participation start point ni' by the size of the capacity range of the battery profile BP, as the negative electrode participation end point nf'.

As another example, when the positive electrode participation end point pf' is determined first, the profile obtaining unit 110 may set a point on the adjusted positive electrode profile Rp', which has a capacity value smaller than the capacity value of the positive electrode participation end point pf' by the size of the capacity range of the battery profile BP, as the positive electrode participation start point pi'. In addition, the profile obtaining unit 110 may search for a point lower than the voltage of positive electrode participation end point pf' by the second set voltage from the adjusted negative electrode profile Rn' and set the searched point as the negative electrode participation end point nf'. In addition, the profile obtaining unit 110 may set a point on the adjusted negative electrode profile Rn', which has a capacity value smaller than the capacity value of the negative electrode participation end point nf' by the size of the capacity range of the battery profile BP, as the negative electrode participation start point ni'.

As still another example, when the negative electrode participation start point ni' is determined, the profile obtaining unit 110 may set a point on the adjusted negative electrode profile Rn', which has a capacity value greater than the capacity value of the negative electrode participation start point ni' by the size of the capacity range of the battery profile BP, as the negative electrode participation end point nf'. In addition, the profile obtaining unit 110 may search for a point higher than the voltage of the negative electrode participation start point ni' by the first set voltage from the adjusted positive electrode profile Rp' and set the searched point as the positive electrode participation start point pi'. In addition, the profile obtaining unit 110 may set a point on the adjusted positive electrode profile Rp', which has a capacity value greater than the capacity value of the positive electrode participation start point pi' by the size of the capacity range of the battery profile BP, as the positive electrode participation end point pf.

As still another example, when the negative electrode participation end point nf' is determined, the profile obtaining unit 110 may set a point on the adjusted negative electrode profile Rn', which has a capacity value smaller than the capacity value of the negative electrode participation end point nf' by the size of the capacity range of the battery profile BP, as the negative electrode participation start point ni'. In addition, the profile obtaining unit 110 may search for a point higher than the voltage of the negative electrode participation end point nf' by the second set voltage from the adjusted positive electrode profile Rp' and set the searched point as the positive electrode participation end point pf'. In addition, the profile obtaining unit 110 may set a point on the adjusted positive electrode profile Rp', which has a capacity value smaller than the capacity value of the positive electrode participation end point pf' by the size of the capacity range of the battery profile BP, as the positive electrode participation start point pi'.

Once the determination of the positive electrode participation start point pi', the positive electrode participation end point pf', the negative electrode participation start point ni' and the negative electrode participation end point nf' is completed based on the pair of first scale factor and second scale factor, the profile obtaining unit 110 may shift at least one of the adjusted positive electrode profile Rp' and the adjusted negative electrode profile Rn' to the left or right along the horizontal axis so that the capacity values of the positive electrode participation start point pi' and the negative electrode participation start point ni' match or the capacity values of the positive electrode participation end point pf' and the negative electrode participation end point nf' match.

The adjusted negative electrode profile Rn" shown in FIG. 11 is obtained by shifting only the adjusted negative electrode profile Rn' shown in FIG. 10 to the right. Accordingly, the capacity values of the positive electrode participation start point pi' and the negative electrode participation start point ni" match each other. In relation to this, since the capacity difference between the positive electrode participation start point pi' and the positive electrode participation end point pf' is the same as the capacity difference between the negative electrode participation start point ni' and the negative electrode participation end point nf', if the capacity values of the positive electrode participation start point pi' and the negative electrode participation start point ni" match each other, the capacity values of the positive electrode participation end point pf' and the negative electrode participation end point nf" also match each other.

Referring to FIG. 11, the profile obtaining unit 110 may generate a comparative profile U by subtracting the partial profile between two points pi', pf' of the adjusted positive electrode profile Rp' from the partial profile between two points ni", nf" of the adjusted negative electrode profile Rn".

The profile obtaining unit 110 may calculate the error (profile error) between the comparative profile U and the battery profile BP.

The profile obtaining unit 110 may map at least two of the adjusted positive electrode profile Rp', the adjusted negative electrode profile Rn", the positive electrode participation start point pi', the positive electrode participation end point pf', the negative electrode participation start point ni", the negative electrode participation end point nf", the first scale factor, the second scale factor, the comparative profile U, and the profile error with each other and record in the storage unit 130.

The profile obtaining unit 110 may calculate a positive electrode change ratio ps based on the reference positive electrode profile Rp and the adjusted positive electrode profile Rp'. Here, the positive electrode change ratio ps means a ratio of the adjusted positive electrode profile changed with respect to the reference positive electrode profile. In addition, the profile obtaining unit 110 may calculate a negative electrode change ratio ns based on the reference negative electrode profile Rn and the adjusted negative electrode profile Rn". Here, the negative electrode change ratio ns means a ratio of the adjusted negative electrode profile changed with respect to the reference negative electrode profile.

For example, the profile obtaining unit 110 may determine the first scale factor as the positive electrode change ratio ps and determine the second scale factor as the negative electrode change ratio ns.

As described above, the profile obtaining unit 110 may generate a comparative profile corresponding to each pair of first scale factor and second scale factor selected from the scaling value range. Since the pair of first scale factor and second scale factor is plural, it is obvious that the comparative profile will also be generated in plural. The profile obtaining unit 110 may identify the minimum value among the profile errors of the plurality of comparative profiles and then obtain information mapped to the minimum profile error from the storage unit 130.

If the comparative profile U shown in FIG. 11 has the minimum profile error in the battery profile BP, the adjusted positive electrode profile Rp' may be used as the positive electrode profile PP, and the adjusted negative electrode profile Rn" may be used as the negative electrode profile NP.

The battery management apparatus 100 according to the present disclosure may be applied to a battery management system (BMS). That is, the BMS according to the present disclosure may include the battery management apparatus 100 described above. In this configuration, at least some of components of the battery management apparatus 100 may be implemented by supplementing or adding functions of the components included in a conventional BMS. For example, the profile obtaining unit 110, the diagnosing unit 120 and the storage unit 130 of the battery management apparatus 100 may be implemented as components of the BMS.

Additionally, the battery management apparatus 100 according to the present disclosure may be provided in the battery pack. That is, the battery pack according to the present disclosure may include the above-described battery management apparatus 100 and at least one battery. Additionally, the battery pack may further include electrical components (relays, fuses, etc.) and a case.

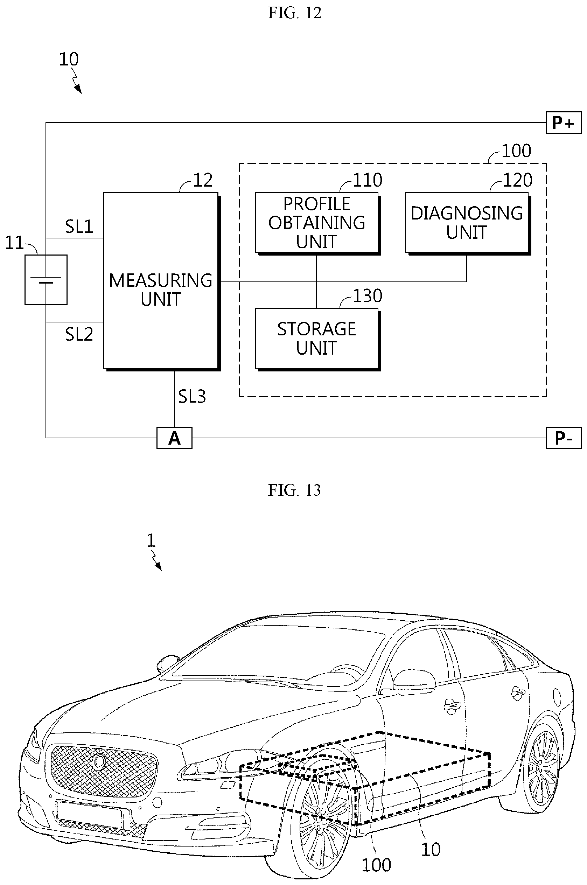

FIG. 12 is a diagram illustrating an exemplary configuration of a battery pack 10 according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to a first sensing line SL1, a second sensing line SL2 and a third sensing line SL3. Specifically, the measuring unit 12 may be connected to the positive electrode terminal of the battery 11 through the first sensing line SL1, and may be connected to the negative electrode terminal of the battery 11 through the second sensing line SL2. The measuring unit 12 may measure the voltage of the battery 11 based on the voltage measured at each of the first sensing line SL1 and the second sensing line SL2.

In addition, the measuring unit 12 may be connected to the current measurement unit A through the third sensing line SL3. For example, the current measurement unit A may be an ammeter or shunt resistor that may measure the charging current and discharging current of the battery 11. The measuring unit 12 may calculate the charging amount by measuring the charging current of the battery 11 through the third sensing line SL3. Additionally, the measuring unit 12 may calculate the discharging amount by measuring the discharging current of the battery 11 through the third sensing line SL3.

One end of an external device (not shown) may be connected to the positive electrode terminal P+ of the battery pack 10, and the other end may be connected to the negative electrode terminal P- of the battery pack 10. Therefore, the positive electrode terminal of the battery 11, the positive electrode terminal P+ of the battery pack 10, the external device, the negative electrode terminal P- of the battery pack 10, and the negative electrode terminal of the battery 11 may be electrically connected.

For example, the external device may be a charging device, or a load such as a motor of an electric vehicle that receives power from the battery 11.

FIG. 13 is a drawing schematically illustrating a vehicle 1 according to another embodiment of the present disclosure.

Referring to FIG. 13, the battery pack 10 according to an embodiment of the present disclosure may be included in the vehicle 1 such as an electric vehicle (EV) or a hybrid vehicle (HV). Here, the battery pack 10 described above may be applied as the battery pack 10. Additionally, the battery pack 10 may drive the vehicle 1 by supplying power to the motor through an inverter provided in the vehicle 1. Additionally, the battery pack 10 may include the battery management apparatus 100 according to an embodiment of the present disclosure. That is, the vehicle 1 may include the battery management apparatus 100. In this case, the battery management apparatus 100 may be an on-board device included in the vehicle 1.

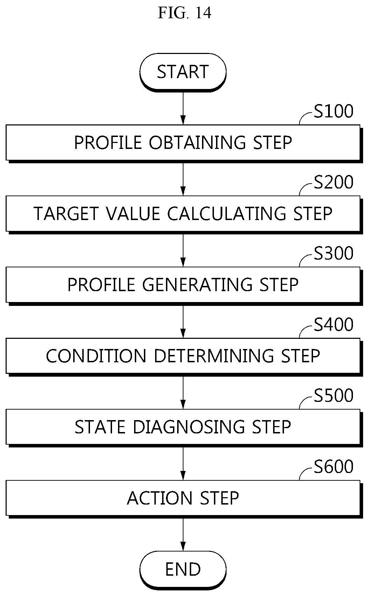

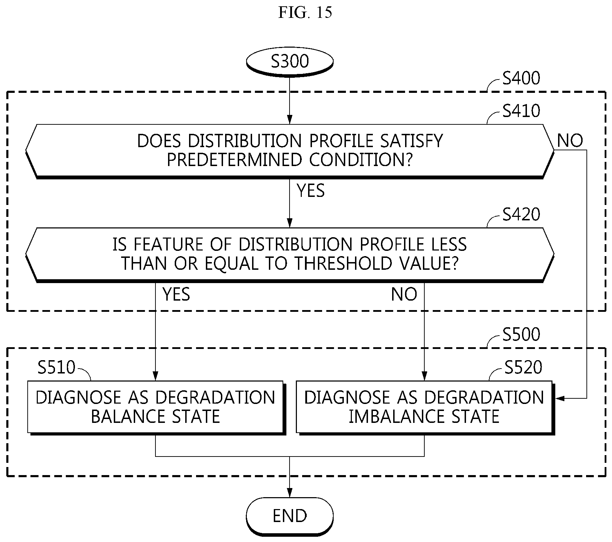

FIG. 14 is a drawing schematically illustrating a battery management method according to another embodiment of the present disclosure, and FIG. 15 is a drawing schematically illustrating a condition determining step and a state diagnosing step of a battery management method according to another embodiment of the present disclosure.

Referring to FIG. 14, the battery management method may include a profile obtaining step (S100), a target value calculating step (S200), a profile generating step (S300), a condition determining step (S400), and a state diagnosing step (S500).

Preferably, each step of the battery management method may be performed by the battery management apparatus 100. Hereinafter, for convenience of explanation, the content overlapping with the previously described content will be briefly described or omitted.

The profile obtaining step (S100) is a step of obtaining a first profile for each of a plurality of batteries included in a battery pack, and may be performed by the profile obtaining unit 110.

Here, the first profile is a positive electrode profile or a negative electrode profile. The target value calculating step (S200) is a step of calculating a target value for each of the plurality of batteries based on a first target point or a target ratio for each of the plurality of first profiles, and may be performed by the diagnosing unit 120.

Here, the first target point is a participation start point or a participation end point included in the first profile. Specifically, if the first profile is a positive electrode profile, the first target point is a positive electrode participation start point or a positive electrode participation end point. If the first profile is a negative electrode profile, the first target point is a negative electrode participation start point or a negative electrode participation end point.

The target ratio is the change ratio for the first profile. Specifically, if the first profile is a positive electrode profile, the target ratio is a positive electrode change ratio. If the first profile is a negative electrode profile, the target ratio is a negative electrode change ratio.

For example, the diagnosing unit 120 may be configured to determine the target value based on a ratio of a capacity value of the first target point to a reference capacity set for each of the plurality of batteries.

The profile generating step (S300) is a step of generating a distribution profile representing the corresponding relationship between the generated plurality of target values and the number of each of the plurality of target values, and may be performed by the diagnosing unit 120.

The condition determining step (S400) is a step for determining whether the distribution profile satisfies a predetermined condition, and may be performed by the diagnosing unit 120.

The state diagnosing step (S500) is a step for diagnosing the state of the battery pack based on the determination result, and may be performed by the diagnosing unit 120.

In the action step (S600), if the battery is determined to be in a degradation imbalance state as a result of the diagnosis, various actions may be taken, which may be performed by the diagnosing unit 120 or a separate control unit (not shown). For example, a low-rate charge may be performed when charging the battery, a pack balancing function may be operated, or an appropriate alarm may be generated so that the user may visit the inspection service and attempt pack balancing or, if necessary, replace the battery pack. According to one embodiment, the receiver of such an alarm output may be an external device that manages the battery pack, such as a BMS, a server, or a user terminal, as well as an external device, a display, or an audio device that diagnoses the state of the battery pack.

Referring to FIG. 15, in step S410, the diagnosing unit 120 may determine whether the distribution profile satisfies a predetermined condition. Specifically, the predetermined condition may be a condition for determining whether the distribution profile follows a Gaussian distribution. In other words, the predetermined condition may be a condition for determining whether the distribution profile exhibits a shape similar to a Gaussian distribution. If the value of step S410 is YES, step S420 may be performed. If the value of step S410 is NO, step S520 may be performed.

In step S420, the diagnosing unit 120 may determine whether a feature value of the distribution profile is less than or equal to a threshold value. The threshold value may be preset based on a BOL state of the battery pack, a current state of the battery pack (e.g., degradation level), a reference value derived from a reference pack corresponding to the battery pack, or a theoretically derived distribution profile. If the value of step S420 is YES, step S510 may be performed. If the value of step S420 is NO, step S520 may be performed.

Referring to FIG. 15, in step S510, the diagnosing unit 120 may diagnose the state of the battery pack as a degradation balance state. In step S520, the diagnosing unit 120 may diagnose the state of the battery pack as a degradation imbalance state.

Here, the degradation balance state refers to a state in which the degradation states of the plurality of batteries included in the battery pack may be viewed as uniform. And, the degradation imbalance state refers to a state in which the degradation states of the plurality of batteries included in the battery pack may be viewed as non-uniform.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

[Explanation of symbols]

    1: vehicle
    10: battery pack
    11: battery
    12: measuring unit
    100: battery management apparatus
    110: profile obtaining unit
    120: diagnosing unit
    130: storage unit

**Claims**

1. A battery management apparatus, comprising:

    a profile obtaining unit configured to obtain a first profile for each of a plurality of batteries included in a battery pack; and
    a diagnosing unit configured to calculate a target value for each of the plurality of batteries based on a first target point or a target ratio for each of a plurality of first profiles, generate a distribution profile representing a corresponding relationship between the calculated plurality of target values and the number of each of the plurality of target values, determine whether the distribution profile satisfies a predetermined condition, and diagnose a state of the battery pack based on the determination result.

2. The battery management apparatus according to claim 1,

wherein the first profile is a positive electrode profile or a negative electrode profile, and wherein the first target point is a participation start point indicating a point where a charging reaction starts or a discharging reaction ends in the first profile, or a participation end point indicating a point where the charging reaction ends or the discharging reaction starts in the first profile.

3. The battery management apparatus according to claim 1, wherein the target ratio is a change ratio of the first profile to a preset reference profile.

4. The battery management apparatus according to claim 1, wherein the diagnosing unit is configured to diagnose the state of the battery pack as a degradation imbalance state when the distribution profile does not satisfy the predetermined condition.

5. The battery management apparatus according to claim 1, wherein the diagnosing unit is configured to compare a feature value of the distribution profile with a preset threshold value when the distribution profile satisfies the predetermined condition, and to diagnose the state of the battery pack based on the comparison result.

6. The battery management apparatus according to claim 5, wherein the diagnosing unit is configured to:

diagnose the state of the battery pack as a degradation imbalance state when the feature value exceeds the threshold value, and diagnose the state of the battery pack as a degradation balance state when the feature value is less than or equal to the threshold value.

7. The battery management apparatus according to claim 5, wherein the diagnosing unit is configured to set the threshold value based on a degradation level of the battery pack and a preset reference feature value.

8. The battery management apparatus according to claim 1, wherein the diagnosing unit is configured to calculate a first value and a second value based on the plurality of target values, and determine whether the distribution profile satisfies the predetermined condition based on a ratio between the first value and the second value.

9. The battery management apparatus according to claim 8, wherein the diagnosing unit is configured to determine a minimum value, a maximum value and a reference value from the plurality of target values, calculate a difference between the minimum value and the reference value as the first value, and calculate a difference between the reference value and the maximum value as the second value.

10. The battery management apparatus according to claim 9, wherein the diagnosing unit is configured to determine a target value with the largest corresponding number among the plurality of target values as the reference value.

11. The battery management apparatus according to claim 8, wherein the diagnosing unit is configured to:

determine the distribution profile as satisfying the predetermined condition when the ratio belongs to a preset threshold ratio section, and determine the distribution profile as not satisfying the predetermined condition when the ratio does not belong to the threshold ratio section.

12. The battery management apparatus according to claim 1, wherein the diagnosing unit is configured to calculate a SOC of the first target point based on a ratio of a capacity value of the first target point to a reference capacity set for each of the plurality of batteries, and determine the calculated SOC as the target value.

13. The battery management apparatus according to claim 1, wherein the diagnosing unit is configured to determine the target ratio as the target value.

14. The battery management apparatus according to claim 1, wherein the diagnosing unit is configured to determine the target value based on a ratio between a reference ratio preset for each of the plurality of batteries and the target ratio.

15. The battery management apparatus according to claim 1,

wherein the diagnosing unit is configured to operate a function to resolve degradation imbalance or output an alarm when the state of the battery pack is diagnosed as a degradation imbalance state.

16. The battery management apparatus according to claim 15,
   wherein the function to resolve degradation imbalance is a pack balancing function.

17. A battery pack, comprising the battery management apparatus according to any one of claims 1 to 16.

18. A vehicle, comprising the battery management apparatus according to any one of claims 1 to 16.

19. A battery management method, comprising:

   a profile obtaining step of obtaining a first profile for each of a plurality of batteries included in a battery pack;
   a target value calculating step of calculating a target value for each of the plurality of batteries based on a first target point or a target ratio for each of a plurality of first profiles;
   a profile generating step of generating a distribution profile representing a corresponding relationship between the calculated plurality of target values and the number of each of the plurality of target values;
   a condition determining step of determining whether the distribution profile satisfies a predetermined condition; and
   a state diagnosing step of diagnosing a state of the battery pack based on the determination result.

20. A non-transitory readable recording medium on which a program is stored to execute a battery management method, which includes a profile obtaining step of obtaining a first profile for each of a plurality of batteries included in a battery pack; a target value calculating step of calculating a target value for each of the plurality of batteries based on a first target point or a target ratio for each of a plurality of first profiles; a profile generating step of generating a distribution profile representing a corresponding relationship between the calculated plurality of target values and the number of each of the plurality of target values; a condition determining step of determining whether the distribution profile satisfies a predetermined condition; and a state diagnosing step of diagnosing a state of the battery pack based on the determination result.

FIG. 1

BATTERY MANAGEMENT APPARATUS ~100

PROFILE OBTAINING UNIT ~110

DIAGNOSING UNIT ~120

STORAGE UNIT ~130

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

```
                      ┌─────────┐
                      │  START  │
                      └─────────┘
                           │
                           ▼              ⌐S100
        ┌──────────────────────────────────┐
        │      PROFILE OBTAINING STEP       │
        └──────────────────────────────────┘
                           │
                           ▼              ⌐S200
        ┌──────────────────────────────────┐
        │    TARGET VALUE CALCULATING STEP  │
        └──────────────────────────────────┘
                           │
                           ▼              ⌐S300
        ┌──────────────────────────────────┐
        │      PROFILE GENERATING STEP      │
        └──────────────────────────────────┘
                           │
                           ▼              ⌐S400
        ┌──────────────────────────────────┐
        │     CONDITION DETERMINING STEP    │
        └──────────────────────────────────┘
                           │
                           ▼              ⌐S500
        ┌──────────────────────────────────┐
        │       STATE DIAGNOSING STEP       │
        └──────────────────────────────────┘
                           │
                           ▼              ⌐S600
        ┌──────────────────────────────────┐
        │            ACTION STEP            │
        └──────────────────────────────────┘
                           │
                           ▼
                      ┌─────────┐
                      │   END   │
                      └─────────┘
```

FIG. 15

```
                           ( S300 )
                              │
  ┌ ─ ─ ─ ─ ─ ─ ─ ─ ─ ─ ─ ─ ─│─ ─ ─ ─ ─ ─ ─ ─ ─ ─ ─ ┐  S400
  │                           ▼                         │  S410
  │    ┌───────────────────────────────────────┐   NO  │
  │   ⟨  DOES DISTRIBUTION PROFILE SATISFY      ⟩──────┐│
  │    ⟨       PREDETERMINED CONDITION?        ⟩       ││
  │    └───────────────────────────────────────┘      ││
  │                        │ YES                       ││
  │                        ▼                       S420││
  │    ┌───────────────────────────────────────┐      ││
  │   ⟨   IS FEATURE OF DISTRIBUTION PROFILE LESS⟩     ││
  │    ⟨   THAN OR EQUAL TO THRESHOLD VALUE?    ⟩      ││
  │    └───────────────────────────────────────┘      ││
  │         │ YES                  │ NO               ││
  └ ─ ─ ─ ─ │ ─ ─ ─ ─ ─ ─ ─ ─ ─ ─ │ ─ ─ ─ ─ ─ ─ ─ ─ ┘│
            │                      │               S500 │
  ┌ ─ ─ ─ ─ │ ─ ─ ─ ─ ─ ─ ─ ─ ─ ─ │ ─ ─ ─ ─ ─ ─ ─ ─ ─ ┐ S520
  │ S510    ▼                      ▼                     │
  │ ┌────────────────────┐  ┌────────────────────┐      │
  │ │ DIAGNOSE AS        │  │ DIAGNOSE AS        │◄─────┘
  │ │ DEGRADATION        │  │ DEGRADATION        │
  │ │ BALANCE STATE      │  │ IMBALANCE STATE    │
  │ └────────────────────┘  └────────────────────┘
  │          │                     │                    │
  └ ─ ─ ─ ─ ─│─ ─ ─ ─ ─ ─ ─ ─ ─ ─ │ ─ ─ ─ ─ ─ ─ ─ ─ ─ ┘
             └──────────┬──────────┘
                        ▼
                    ( END )
```

## INTERNATIONAL SEARCH REPORT

| International application No. |
|---|
| **PCT/KR2025/000681** |

### A. CLASSIFICATION OF SUBJECT MATTER

**G01R 31/392**(2019.01)i; **G01R 31/396**(2019.01)i; **G01R 31/382**(2019.01)i

According to International Patent Classification (IPC) or to both national classification and IPC

### B. FIELDS SEARCHED

Minimum documentation searched (classification system followed by classification symbols)

G01R 31/392(2019.01); G01R 19/00(2006.01); G01R 31/36(2006.01); G01R 31/367(2019.01); G06N 3/08(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 팩(battery Pack), 프로파일(profile), 분포(distribution), 상태(state), 진단 (diagnosis)

### C. DOCUMENTS CONSIDERED TO BE RELEVANT

| Category* | Citation of document, with indication, where appropriate, of the relevant passages | Relevant to claim No. |
|---|---|---|
| X | KR 10-2023-0136998 A (KOREA INSTITUTE OF ENERGY RESEARCH et al.) 04 October 2023 (2023-10-04)<br>See paragraphs [0031]-[0072], claim 1, and figures 1-10. | 1,4,17-20 |
| Y | | 15-16 |
| A | | 2-3,5-14 |
| Y | KR 10-2024-0003170 A (SK ON CO., LTD.) 08 January 2024 (2024-01-08)<br>See paragraph [0044] and figure 2. | 15-16 |
| A | KR 10-2023-0167249 A (SK INNOVATION CO., LTD. et al.) 08 December 2023 (2023-12-08)<br>See paragraphs [0041]-[0116] and figures 2-12. | 1-20 |
| A | KR 10-2021-0154027 A (LG ENERGY SOLUTION, LTD.) 20 December 2021 (2021-12-20)<br>See paragraphs [0035]-[0185] and figures 1-7. | 1-20 |

☑ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **10 April 2025** | **11 April 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2025/000681**

| C. | DOCUMENTS CONSIDERED TO BE RELEVANT | |
| --- | --- | --- |
| Category* | Citation of document, with indication, where appropriate, of the relevant passages | Relevant to claim No. |
| A | KR 10-2022-0102472 A (LG ENERGY SOLUTION, LTD.) 20 July 2022 (2022-07-20)<br>See paragraphs [0033]-[0106] and figures 1-6. | 1-20 |

Form PCT/ISA/210 (second sheet) (July 2022)

**INTERNATIONAL SEARCH REPORT**
Information on patent family members

International application No.

**PCT/KR2025/000681**

| Patent document cited in search report | | | Publication date (day/month/year) | Patent family member(s) | | | Publication date (day/month/year) |
|---|---|---|---|---|---|---|---|
| KR | 10-2023-0136998 | A | 04 October 2023 | None | | | |
| KR | 10-2024-0003170 | A | 08 January 2024 | WO | 2024-005338 | A1 | 04 January 2024 |
| KR | 10-2023-0167249 | A | 08 December 2023 | CN | 117148154 | A | 01 December 2023 |
| | | | | US | 2023-0384392 | A1 | 30 November 2023 |
| KR | 10-2021-0154027 | A | 20 December 2021 | None | | | |
| KR | 10-2022-0102472 | A | 20 July 2022 | CN | 115956207 | A | 11 April 2023 |
| | | | | EP | 4198536 | A1 | 21 June 2023 |
| | | | | JP | 2023-528058 | A | 03 July 2023 |
| | | | | JP | 7546700 | B2 | 06 September 2024 |
| | | | | US | 2023-0213589 | A1 | 06 July 2023 |
| | | | | WO | 2022-154545 | A1 | 21 July 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240005648
- KR 1020240005656
- KR 1020240005647
- KR 1020240005634
- KR 1020240005640
- KR 1020240005657